# EUROPÄISCHE PATENTANMELDUNG

(11) **EP 1 441 364 A1**
(43) Veröffentlichungstag der Anmeldung: **28.07.2004**
(21) Anmeldenummer: 03001253.8
(22) Anmeldetag: 21.01.2003
(51) Int. Cl.: G11C 17/12

(54) **ROM-Speicher und Verfahren zum Auslesen des ROM-Speichers**

(71) Anmelder: Fraunhofer-Gesellschaft zur Förderung der angewandten Forschung e.V., 80686 München (DE)
(72) Erfinder: Hermann, Rüdiger, 01328 Dresden (DE); Holland, Hans-Jürgen, 01328 Dresden (DE); Erler, Olaf, 01728 Bannewitz (DE)
(74) Vertreter: Schoppe, Fritz, Dipl.-Ing.

(57) **Zusammenfassung**

Ein ROM-Speicher umfaßt eine erste Speicherzelle (201) und einer der ersten Speicherzelle benachbarten zweite Speicherzelle (203), wobei die erste und die zweite Speicherzelle jeweils einen Speichertransistor mit einem ersten und einem zweiten Leitungsanschluß und einem Steueranschluß aufweisen, eine Wortleitung (209), eine erste und eine zweite Bitleitung (205,207), wobei die zweite Bitleitung der ersten Bitleitung benachbart ist, wobei durch die erste Bitleitung die erste Speicherzelle auslesbar ist und wobei durch die zweite Bitleitung die zweite Speicherzelle auslesbar ist, wobei die erste Bitleitung mit dem ersten Leitungsanschluß des Speichertransistors der ersten Speicherzelle, unabhängig von einem Speicherzustand, der in der ersten Speicherzelle speicherbar ist, verbunden ist, wobei die zweite Bitleitung mit dem zweiten Leitungsanschluß des Speichertransistors der ersten Speicherzelle verbunden ist, wobei der Steueranschluß der ersten Speicherzelle zum Speichern eines ersten Zustands mit der Wortleitung verbunden ist oder zum Speichern eines zweiten Zustands, der sich von dem ersten Zustand unterscheidet, mit der zweiten Bitleitung verbunden ist, eine Einrichtung (213) zum Legen der zweiten Bitleitung auf ein Referenzpotential, wenn die erste Bitleitung auf ein Bitleitungslesepotential gelegt wird, und eine Einrichtung (211) zum Auslesen, wobei die Einrichtung zum Auslesen ausgebildet ist, um die erste Bitleitung auf das Bitleitungslesepotential zu legen und die Wortleitung auf ein Wortleitungslesepotential zu legen, wobei ein stabiles Potential auf der ersten Bitleitung den zweiten Zustand in der ersten Speicherzelle anzeigt und ein bezüglich des Bitleitungslesepotentials verändertes Potential auf der ersten Bitleitung den ersten Zustand in der ersten Speicherzelle anzeigt.

## Beschreibung

Die vorliegende Erfindung bezieht sich auf einen ROM-Speicher (ROM; ROM = read-only memory) sowie auf ein Verfahren zum Auslesen des ROM-Speichers, wobei der ROM-Speicher Speicherzellen aufweist, deren jeweiliger Speicherzustand mit Hilfe einer Maske programmierbar ist.

Mit einem steigenden Integrationsgrad sowie mit einer steigenden Komplexität moderner Speicher ist es notwendig, Speicher bereitzustellen, die einen geringen Flächen- und Leistungsverbrauch aufweisen. Insbesondere bei ROM-Speichern ist es ferner von Bedeutung, daß sie effizient programmiert werden können, da ein ROM-Speicher beispielsweise aus einer Vielzahl von Speicherzellen besteht, deren jeweiliger Speicherzustand, beispielsweise logisch "0" oder logisch "1", mit Hilfe von Masken, die auf vorgefertigte Wafer angewendet, programmiert werden können. Die bekannten Verfahren verwenden zum Programmieren Ebenen aus einem Metallisierungskomplex, die in der Literatur als VIA CODE MASK oder MetalROM bezeichnet werden. Diese maskenprogrammierbaren ROM werden vorzugsweise in größeren Designs, wie Mikroprozessoren und ähnliches, verwendet. Eine Korrektur der Programmierung in einem Technologieschritt in einem Metallisierungsprozeß ist hier oft vorteilhaft. Vorgefertigte Wafer können in einem oxidierten Polysilizium beliebige lange konserviert werden und nach einer eventuellen Korrektur der Programmierung zu Ende gefertigt werden. Darüber hinaus sollen, wie bereits erwähnt, eingebettete ROM (embedded ROM) eine kleine Fläche einnehmen, einen geringen Aktivstromverbrauch aufweisen und einen schnellen Datenzugriff gewährleisten. In der Schrift US 2001/028574 A1 wird eine Erfindung beschrieben, die in einem Kontaktfensterkomplex programmiert wird und eine kleine Fläche aufweisen soll.

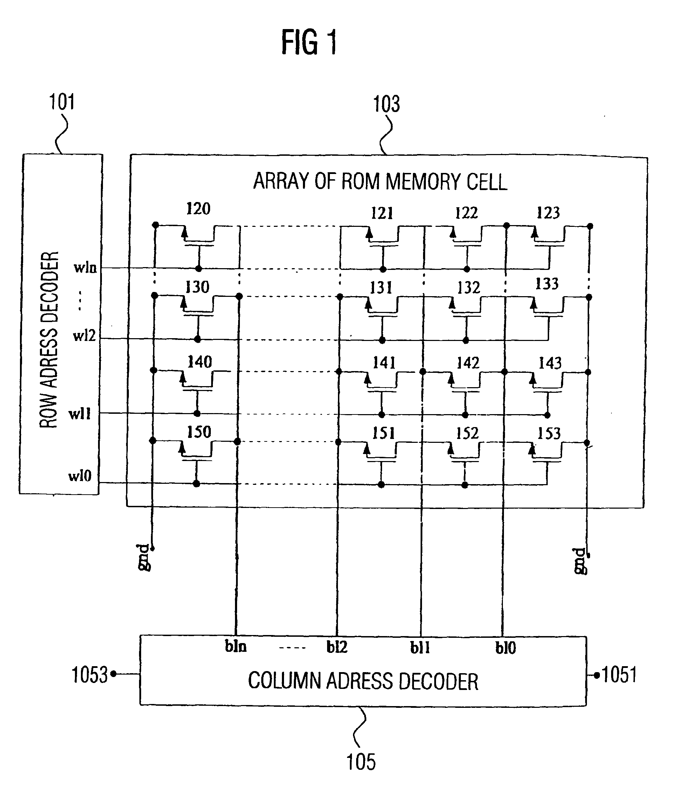

Fig. 1 zeigt einen ROM-Speicher gemäß der in der oben genannten Schrift offenbarten Lösung. Der ROM-Speicher weist einen Zeilenadreßdecoder (row address decoder) 101, ein Array von ROM-Speicherzellen (ROM memory cell) 103 und einen Spaltenadreßdecoder (column address decoder) 105 auf. Das Array der ROM-Speicherzellen 103 umfaßt ferner Speichertransistoren 120 - 153, wobei die Speichertransistoren in einer Arrayspalte jeweils in Serie geschaltet sind. Die Gates der Speichertransistoren 120 - 153 sind mit Wortleitungen w10 - wln verbunden, wobei jeder Arrayspalte eine Wortleitung zugeordnet ist. Die Speichertransistoren 120 - 153 sind ferner so angeordnet, daß sie zwischen Bitleitungen b10 - b1n liegen. Links und rechts sind jeweils Leitungen erforderlich, die mit Masse (ground) verbunden sind, über die die Speichertransistoren einer der Wortleitungen w10 - wln die Ladung aller programmierten Bitleitungen entladen. Die Speichertransistoren einer Wortleitung bilden logisch ein UND. Soll eine Bitleitung nicht entladen werden, so ist kein Kontakt der Source-/Draingebiete zweier benachbarter Transistoren zu der gemeinsamen Bitleitung hergestellt, wie es beispielsweise in Fig. 1 zwischen den Transistoren 151 und 152 dargestellt ist, die keine Verbindung zur Bitleitung b11 aufweisen.

Ist beispielsweise nur die Bitleitung b10 aktiv, so sind die Transistoren 150 - 153 eingeschaltet. Wird auf die Bitleitung b11 eine Spannung angelegt, die eine logische "1" (high) repräsentiert, und sind die übrigen Bitleitungen auf "0" gesetzt (low), so ist ein logisches Level der Bitleitung b11 "1", da kein Strom über die Transistoren 152 und 153 in Richtung der Groundleitung fließt. Wird hingegen nur die Wortleitung w11 aktiviert und sind alle anderen Wortleitungen nicht aktiviert, so sind die Speichertransistoren 140 - 143 eingeschaltet. Da die Source-/Draingebiete der Transistoren 141 und 142 mit der Bitleitung verbunden sind, bildet sich ein Stromfluß in Richtung der Groundleitung aus, wenn auf der Bitleitung b11 eine logische "1" anliegt. Aufgrund des Stromflusses sinkt das Potential auf der Bitleitung b11, so daß das logische Level auf der Bitleitung b11 der "0" entspricht.

Aufgrund der in Fig. 1 dargestellten Struktur ist es notwendig, alle auf "Low" programmierten Bitleitungen nach Ground zu entladen, was zu einem höheren Leistungsverbrauch führt. Darüber hinaus gestattet die in Fig. 1 dargestellte Lösung es nicht, mehr als zwei benachbarte Transistoren gemeinsam an eine Bitleitung anzuschließen. Da die Groundleitungen jeweils links und rechts angeordnet sind, ist die Auslesegenauigkeit verringert, da an den jeweiligen in Serie geschalteten Speichertransistoren jeweils eine Teilspannung abfällt. Darüber hinaus verringert sich aufgrund einer derartigen Anordnung der Groundleitungen die Zugriffszeit mit einem wachsenden Abstand des jeweiligen Speichertransistors zu der nächstgelegenen Groundleitung. Nachteil an dem in Fig. 1 gezeigten ROM-Speicher, wie er aus dem Stand der Technik bekannt ist, ist ferner, daß eine Entladung über alle Speichertransistoren in einer Zeile erfolgt, wenn die jeweilige Wortleitung mit einer Spannung beaufschlagt ist und wenn auf einer Bitleitung ein Low-Zustand programmiert ist.

Um schnellere Zugriffszeiten zu erreichen sowie um zu vermeiden, daß die Entladung über alle Speichertransistoren erfolgt, kann beispielsweise jedem Speichertransistor eine Groundleitung zugeordnet werden, wie es aus dem Stand der Technik und aus der oben genannten Schrift bekannt ist. Der Nachteil dieser Lösung besteht jedoch darin, daß die zusätzlichen Groundleitungen zusätzliche Fläche benötigen.

Die Aufgabe der vorliegenden Erfindung besteht darin, einen ROM-Speicher zu schaffen, der einen geringen Flächenverbrauch, kurze Zugriffszeiten sowie einen geringen Leistungsverbrauch aufweist.

Diese Aufgabe wird durch einen ROM-Speicher gemäß Anspruch 1 oder durch ein Verfahren gemäß Anspruch 16 oder durch ein Verfahren gemäß Anspruch 18 gelöst.

Der vorliegenden Erfindung liegt die Erkenntnis zugrunde, daß jede der Bitleitungen zu einer Groundleitung werden kann, wenn an sie beispielsweise ein Massepotential gelegt wird, oder sie kann zu einer aktiven Leitung werden, wenn auf sie ein Bitleitungslesepotential gelegt wird. Ist beispielsweise eine Speicherzelle zwischen einer ersten und einer zweiten Bitleitung angeordnet, so kann zum Auslesen des in der Speicherzelle gespeicherten Zustands auf die erste Bitleitung ein Bitleitungslesepotential und auf die zweite Bitleitung ein Referenzpotential, beispielsweise ein Massepotential, gelegt werden. Dadurch wird erreicht, daß sich ein Stromfluß nur über diese Zelle ausbildet und daß die Zugriffszeit verkürzt wird, da die zweite, benachbarte Bitleitung beispielsweise zu einer Groundleitung wird. Zum Auslesen einer weiteren Speicherzelle, die mit der zweiten Bitleitung verbunden ist, wird die zweite Bitleitung von dem Referenzpotential getrennt und es wird auf die zweite Bitleitung ein Bildleitungslesepotential gelegt, so daß die zweite Bitleitung zu der momentan aktiven Bitleitung wird.

Ein Vorteil der vorliegenden Erfindung liegt darin, daß die Zugriffszeiten reduziert werden, da jede der Bitleitungen, also auch die der jeweiligen Speicherzelle am nächsten liegende Bitleitung, mit einem Referenzpotential beaufschlagt werden kann, wodurch sie beispielsweise zu einer Groundleitung wird. Dabei entsteht kein zusätzlicher Flächenbedarf.

Ein weiterer Vorteil der vorliegenden Erfindung besteht darin, daß der in der jeweiligen Speicherzelle gespeicherte Zustand genau ausgelesen werden kann, da die jeweilige Bitleitung nur über diese Speicherzelle entladen wird.

Bevorzugte Ausführungsbeispiele der vorliegenden Zeichnungen werden nachfolgend Bezug nehmend auf die beiliegenden Zeichnungen näher erläutert. Es zeigen:
- Fig. 1: einen ROM-Speicher;
- Fig. 2: einen ROM-Speicher gemäß einem ersten Ausführungsbeispiel der vorliegenden Erfindung;
- Fig. 3: einen ROM-Speicher gemäß einem zweiten Ausführungsbeispiel der vorliegenden Erfindung;
- Fig. 4: einen ROM-Speicher gemäß einem dritten Ausführungsbeispiel der vorliegenden Erfindung;
- Fig. 5: einen ROM-Speicher gemäß einem vierten Ausführungsbeispiel der vorliegenden Erfindung;
- Fig. 6: einen ROM-Speicher gemäß einem fünften Ausführungsbeispiel der vorliegenden Erfindung; und
- Fig. 7: einen ROM-Speicher gemäß einem sechsten Ausführungsbeispiel der vorliegenden Erfindung.

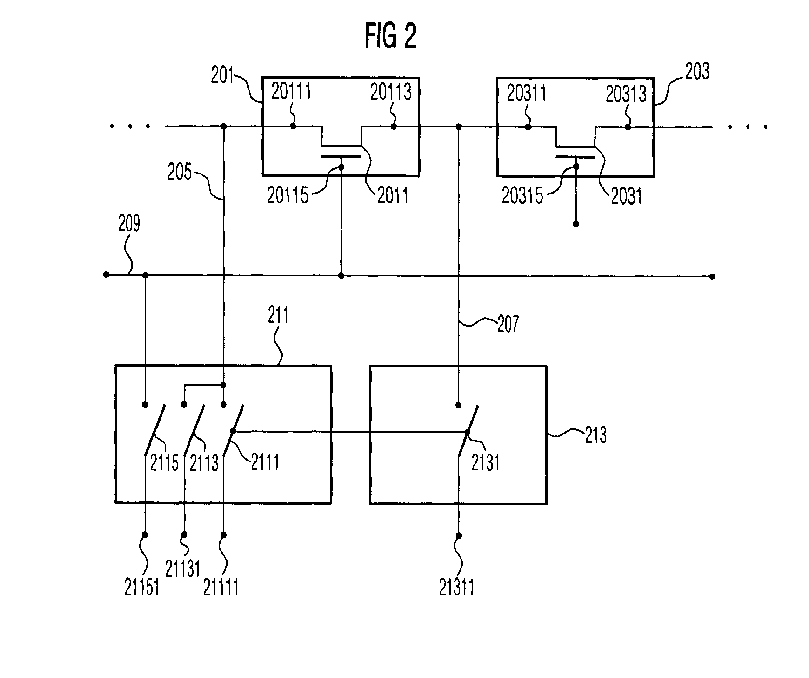

Fig. 2 zeigt einen ROM-Speicher gemäß einem ersten Ausführungsbeispiel der vorliegenden Erfindung. Der ROM-Speicher umfaßt zunächst eine erste Speicherzelle 201, die einen Speichertransistor 2011 mit einem ersten Leitungsanschluß 20111, einem zweiten Leitungsanschluß 20113 und einem Steueranschluß 20115 aufweist. Der ersten Speicherzelle 201 ist eine zweite Speicherzelle 203 benachbart, die einen Speichertransistor 2031 mit einem ersten Leitungsanschluß 20311, einem zweiten Leitungsanschluß 20313 und einem Steueranschluß 20315 aufweist. Der erste Leitungsanschluß 20111 des Speichertransistors 2011 ist mit einer ersten Bitleitung 205 gekoppelt. Der zweite Leitungsanschluß 20113 des Speichertransistors 2011 ist mit dem ersten Leitungsanschluß 20311 des Speichertransistors 2031 und mit einer zweiten Bitleitung 207 gekoppelt. Der ROM-Speicher in Fig. 2 weist ferner eine Wortleitung 209 auf, die mit dem Steueranschluß 20115 des Speichertransistors 2011 zum Speichern eines ersten Zustands gekoppelt ist. Der ROM-Speicher weist ferner eine Einrichtung 211 zum Auslesen sowie eine Einrichtung 213 zum Legen der zweiten Bitleitung 207 auf ein Referenzpotential auf. Die Einrichtung 211 zum Auslesen weist ferner einen ersten Schalter 2111, der steuerbar ist, auf. Der Schalter 2111 ist zwischen die erste Bitleitung 205 und einen ersten Anschluß 21111 gekoppelt. Die Einrichtung zum Auslesen 211 weist ferner einen zweiten Schalter 2113 auf, der zwischen die erste Bitleitung 205 und einen Anschluß 21131 gekoppelt ist. Die Einrichtung 213 zum Legen der zweiten Bitleitung 207 auf das Referenzpotential weist einen dritten Schalter 2131 auf, der zwischen die zweite Bitleitung 207 und einen Anschluß 21311 gekoppelt ist. Die Steueranschlüsse der Schalter 2131 und 2111 sind ferner, wie in diesem Ausführungsbeispiel gezeigt ist, miteinander verbunden. Die Einrichtung 211 zum Auslesen weist darüber hinaus einen dritten Schalter 2115 auf, der zwischen die Wortleitung 209 und einen Anschluß 21151 gekoppelt ist.

Im folgenden wird die Funktionsweise des in Fig. 2 dargestellten ROM-Speichers erklärt.

Der Speicherzustand in der Speicherzelle 201 ist dadurch festgelegt, daß der Steueranschluß 20115 des Speichertransistors 2011 mit der Wortleitung 209 verbunden ist. Aus diesem Grund wird im folgenden dieser Speicherzustand als ein erster Zustand bezeichnet. Zum Auslesen des in der Speicherzelle 201 gespeicherten ersten Zustands wird an die Wortleitung 209 ein Wortleitungslesepotential gelegt. Das Legen des Wortleitungslesepotentials auf die Wortleitung 209 wird mit Hilfe des Schalters 2115 bewerkstelligt, da an den Anschluß 21151 das Wortleitungslesepotential anlegbar ist. Wird nun an den Anschluß 21151 das Wortleitungslesepotential angelegt und wird der Schalter 2115 geschlossen, so wird die Wortleitung 209 mit dem Wortleitungslesepotential beaufschlagt, so daß der Transistor 2011, der in diesem Ausführungsbeispiel als ein n-Kanal-Feldeffekttransistor ausgeführt ist, aktiviert obzw. eingeschaltet wird. Zum Auslesen des in der Speicherzelle 201 gespeicherten ersten Zustands wird ferner die erste Bitleitung 205 auf ein Bitleitungslesepotential gelegt. Hierzu wird der Schalter 2111, an dessen Anschluß 21111 das Bitleitungslesepotential anlegbar ist, geschlossen. Wird gleichzeitig die zweite Bitleitung 207 mit Hilfe des Schalters 2131, an dessen Anschluß 21311 ein Referenzpotential anlegbar ist, mit dem Referenzpotential beaufschlagt, wobei das Referenzpotential sich von dem Bitleitungslesepotential unterscheidet, so bildet sich ein Stromfluß von der ersten Bitleitung 205 durch den Transistor 2011 zur zweiten Bitleitung 207 aus, falls das Referenzpotential niedriger als das Bitleitungslesepotential ist. Gleicht das Referenzpotential einem Massepotential, so wird die zweite Bitleitung 207 nach einem Schließen des Schalters 2131 zu einer Groundleitung.

Aufgrund des Stormflusses durch den Transistor 2011 wird das Potential auf der ersten Bitleitung 205 verringert oder, in anderen Worten ausgedrückt, "in Richtung des Referenzpotentials" gezogen, so daß sich auf der Bitleitung 205 ein bezüglich des Bitleitungslesepotentials verändertes, niedrigeres Potential einstellt, das den ersten Zustand in der ersten Speicherzelle 201 anzeigt. Zum Auslesen des veränderten Potentials kann der Schalter 2113 geschlossen werden, so daß an dem Anschluß 21131 das veränderte Potential abgegriffen werden kann.

In dem in Fig. 2 dargestellten Ausführungsbeispiel sind die Steueranschlüsse der Schalter 2111 und 2131 miteinander verbunden, um zu verdeutlichen, daß die zweite Bitleitung 207 nur dann mit dem Referenzpotential verbunden wird, wenn auf die erste Bitleitung 205 zum Auslesen des in der ersten Speicherzelle 201 gespeicherten ersten Zustands das Bitleitungslesepotential mit Hilfe des Schalters 2111 gelegt wird. Ein Öffnen und ein Schließen der Schalter 2111 und 2131 kann jedoch durch ein geeignetes Ansteuersignal realisiert werden, wobei das Ansteuersignal ebenfalls den Schalter 2113 zum Auslesen des sich auf der ersten Bitleitung 205 einstellenden Potentials steuert. Durch ein Anlegen des Steuersignals an die Steueranschlüsse der Schalter 2113, 2111 und 2131 werden beispielsweise die Schalter zum Auslesen des in der ersten Speicherzelle 201 gespeicherten ersten Zustands geschlossen und beispielsweise nach dem Auslesen des sich auf der ersten Bitleitung 205 einstellenden Potentials über den Anschluß 21131 wieder geöffnet, so daß sowohl die erste Bitleitung 205 von dem Bitleitungslesepotential als auch die zweite Bitleitung 207 von dem Referenzpotential getrennt werden. Nach einem Auslesevorgang kann dann die zweite Bitleitung 207 beispielsweise zum Auslesen eines in der zweiten Speicherzelle 203 gespeicherten zweiten Zustands, der in Fig. 2 nicht eingezeichnet ist, auf eine analoge Weise herangezogen werden.

Zum Begrenzen des durch den Speichertransistor 2011 während des Auslesens der ersten Speicherzelle 201 fließenden Stroms sind ferner unter Umständen Strombegrenzungsmaßnahmen möglich, um den Stromverbrauch begrenzen bzw. zu senken. Hierzu kann beispielsweise das Referenzpotential nur ein wenig geringer sein als das Bitleitungslesepotential, so daß sich ein geringer Stromfluß ausbildet. Die Differenz zwischen dem Bitleitungslesepotential und dem Referenzpotential muß jedoch in diesem Fall ausreichend groß sein, damit das auf der ersten Bitleitung 205 sich einstellende veränderte Potentials dennoch eindeutig und genau ausgelesen werden kann. Es sind jedoch auch weitere, beispielsweise schaltungstechnische, Strombegrenzungsmaßnahmen denkbar, wie sie im Zusammenhang mit dem Auslesen der ROM-Speicher, die aus dem Stand der Technik bekannt sind, verwendet werden.

In dem in Fig. 2 dargestellten Ausführungsbeispiel werden zum Legen der jeweiligen Potentiale auf die erste Bitleitung 205, auf die zweite Bitleitung 207 sowie auf die Wortleitung 209 sowie zum Auslesen des sich auf der ersten Bitleitung 205 einstellenden Potentials Schalter verwendet. An dieser Stelle sei jedoch darauf hingewiesen, daß eine Potentiallegung auf die jeweiligen Leitungen mit Hilfe von beliebigen Funktionalitäten bewerkstelligt werden kann. Hierzu können beispielsweise geeignet gesteuerte Spannungsquellen eingesetzt werden.

Des weiteren umfassen die in Fig. 2 dargestellten Speicherzellen Feldeffekttransistoren 2011 sowie 2031, die in diesem Ausführungsbeispiel als n-Kanal-Feldeffekttransistoren ausgebildet sind. An dieser Stelle sei jedoch darauf hingewiesen, daß die Speichertransistoren 2011 sowie 2031 beliebige Transistoren sein können, also auch beispielsweise p-Feldeffekttransistoren (selbstleitend oder selbstsperrend) oder auch Bipolartransistoren.

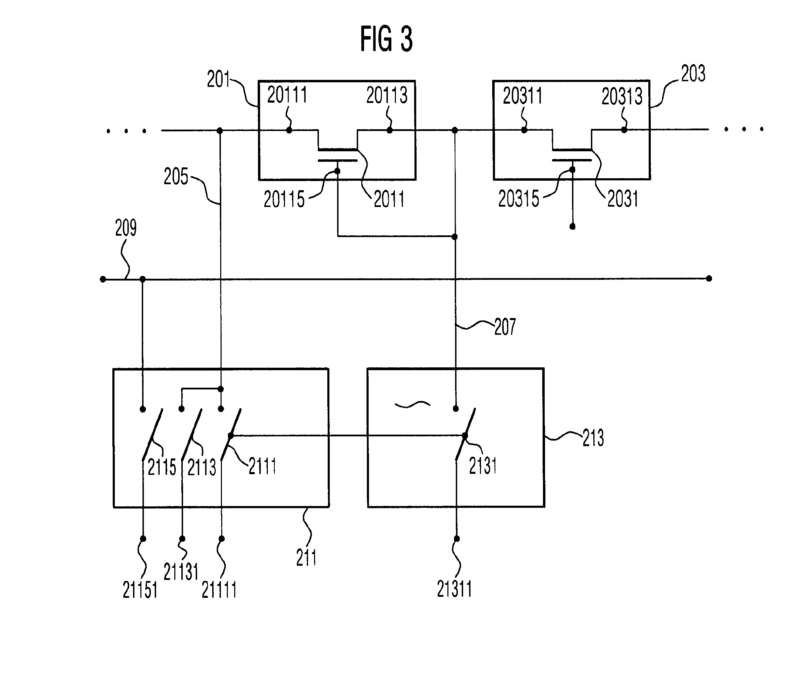

In Fig. 3 ist ein zweites Ausführungsbeispiel des ROM-Speichers gemäß der vorliegenden Erfindung dargestellt. Im Unterschied zu dem in Fig. 2 dargestellten Ausführungsbeispiel ist der Steueranschluß 20115 des Speichertransistors 2011 mit der zweiten Bitleitung 207 verbunden. Im folgenden wird daher auf diesen Unterschied eingegangen, ohne daß der in Fig. 2 bereits diskutierte Aufbau des ROM-Speichers sowie dessen grundsätzliche Funktionsweise erneut beschrieben werden.

Da der Steueranschluß 20115 des Transistors 2011 der ersten Speicherzelle 201 mit der zweiten Bitleitung 207 verbunden ist, wird in der Speicherzelle 201 ein im Vergleich zu der Schaltung aus Fig. 2 unterschiedlicher Speicherzustand realisiert, der im folgenden als ein zweiter Zustand bezeichnet wird. Wird auf die erste Bitleitung 205 mittels des Schalters 2111 das Bitleitungslesepotential gelegt und wird auf die zweite Bitleitung 207 mittels des Schalters 2131 das Referenzpotential gelegt, so fließt durch den Transistor 2011 kein Strom, wenn der Speichertransistor 2011 beispielsweise ein n-Kanal-Feldeffekttransistor ist und wenn das Referenzpotential niedriger als das Bitleitungslesepotential ist. Der Speichertransistor 2011 ist in diesem Fall ausgeschaltet, d. h. er befindet sich in einem "Aus"-Zustand, unabhängig davon, ob auf die Wortleitung 209 ein Wortleitungslesepotential gelegt wird oder nicht. Da durch die Speicherzelle 201 kein oder ein sehr geringer Strom fließt, ist das sich auf der ersten Bitleitung 205 einstellende Potential stabil bezüglich des Bitleitungslesepotentials. In anderen Worten ausgedrückt, befindet sich die erste Bitleitung 205 in einem Leerlaufzustand. Auf diese Weise wird daher auf der ersten Bitleitung 205 ein "High" programmiert, das den zweiten Zustand in der ersten Speicherzelle 201 anzeigt. Dieses bezüglich des Bitleitungslesepotentials stabile Potential auf der ersten Bitleitung 205 kann nun beispielsweise nach dem Schließen des Schalters 2113 an dem Anschluß 21131 abgegriffen werden.

Ein Vorteil dieser erfindungsgemäßen Anordnung zum Speichern des zweiten Zustands in der ersten Speicherzelle 201 liegt darin, daß der in der ersten Speicherzelle 201 gespeicherte zweite Zustand in einem Idealfall stromlos ausgelesen werden kann, wenn das stabile Potential auf der ersten Bitleitung 205 beispielsweise mit Hilfe einer hochohmigen Schaltung ausgelesen wird. Durch diese erfindungsgemäße Anordnung wird ferner erreicht, daß eine Leistungsaufnahme des ROM-Speichers bei dem Auslesen der ersten Speicherzelle 201 sehr gering ist, da ein Aktivstrom sehr klein gehalten werden kann.

Da der Transistor 2011 zum Speichern des zweiten Zustands in der ersten Speicherzelle 201 ausgeschaltet ist, kann diese erfindungsgemäße Anordnung bereits bei einem Herstellungsprozeß eines Substrats, auf dem die Speichertransistoren ausgebildet werden, berücksichtigt werden, indem der zweite Zustand dadurch realisiert wird, daß der jeweilige Transistor nicht ausgebildet wird.

In dem in Fig. 3 dargestellten Ausführungsbeispiel werden die Schalter 2111 und 2131 gemeinsam geöffnet und geschlossen. Wie es im Zusammenhang mit dem in Fig. 2 dargestellten Ausführungsbeispiel bereits diskutiert worden ist, kann das Steuern dieser Schalter sowie des Schalters 2113 durch ein Ansteuersignal realisiert werden. An dieser Stelle sei jedoch angemerkt, daß die Schalter 2111, 2131 und 2113 sowohl in dem in Fig. 2 dargestellten Ausführungsbeispiel als auch in dem in Fig. 3 dargestellten Ausführungsbeispiel unabhängig voneinander angesteuert werden können. In diesem Fall wird beispielsweise zum Auslesen der ersten Speicherzelle 201 zuerst der Schalter 2111 geschlossen, wodurch die erste Bitleitung 205 mit dem Bitleitungslesepotential beaufschlagt wird. Danach kann der Schalter 2131 angesteuert werden, so daß an die zweite Bitleitung 207 das Referenzpotential angelegt wird. Der Schalter 2113 kann danach zum Auslesen des sich auf der ersten Bitleitung 205 einstellenden Potentials geschlossen werden, wodurch gewährleistet werden kann, daß beispielsweise das Auslesen der ersten Speicherzelle während einer Potentialübergangsphase, in der sich das bezüglich des Bitleitungslesepotentials veränderte Potential einstellt, die erste Speicherzelle 201 nicht ausgelesen wird. Der Vorteil einer derartigen Vorgehensweise liegt darin, daß die erste Speicherzelle 201 dann ausgelesen wird, wenn das sich auf der ersten Bitleitung 205 einstellende Potential bereits stabilisiert ist.

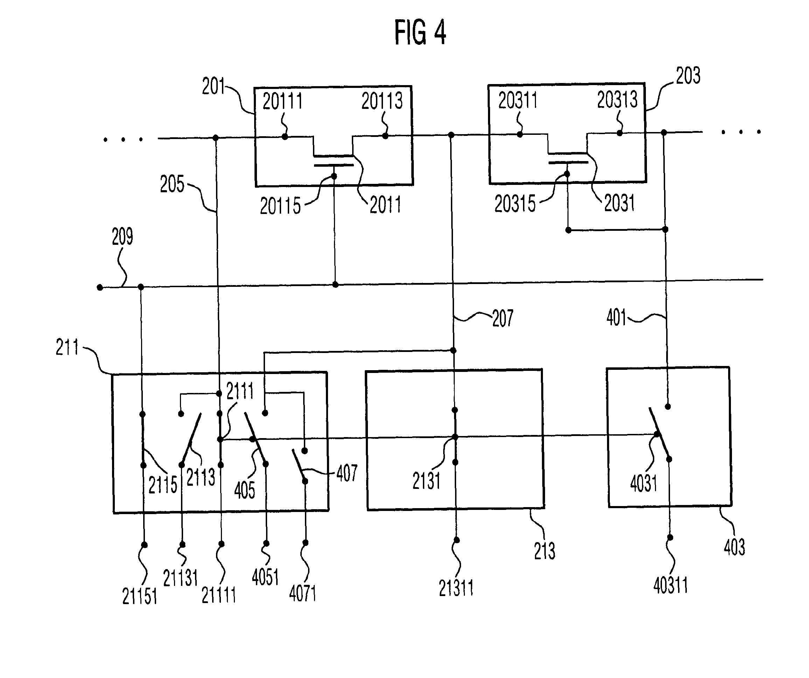

In Fig. 4 ist ein drittes Ausführungsbeispiel des ROM-Speichers gemäß der vorliegenden Erfindung gezeigt. Im Unterschied zu den in Fig. 2 und in Fig. 3 dargestellten Ausführungsbeispielen weist der in Fig. 4 dargestellte ROM-Speicher eine weitere Bitleitung 401 auf, die mit dem zweiten Leitungsanschluß 20313 des Speichertransistors 2031 gekoppelt ist. Zum Speichern des ersten Zustands in der ersten Speicherzelle 201 ist der Steueranschluß 20115 des Speichertransistors 2011 der ersten Speicherzelle 201 mit der Wortleitung 209 gekoppelt, und zum Speichern des zweiten Speicherzustands in der zweiten Speicherzelle 203 ist der Steueranschluß 20315 des Speichertransistors 2031 der zweiten Speicherzelle 203 mit der weiteren Bitleitung 401 gekoppelt.

Im Unterschied zu den in Fig. 2 und Fig. 3 dargestellten Ausführungsbeispielen weist der in Fig. 4 dargestellte ROM-Speicher ferner eine weitere Einrichtung 403 zum Legen der weiteren Bitleitung 401 auf das Referenzpotential auf. Die weitere Einrichtung 403 umfaßt einen Schalter 4031, der zwischen die weitere Bitleitung 401 und einen Anschluß 4031, an den das Referenzpotential anlegbar ist, gekoppelt ist. Die Einrichtung 211 zum Auslesen weist ferner einen Schalter 405, der zwischen die zweite Bitleitung 207 und einen Anschluß 4051 gekoppelt ist, sowie einen Schalter 407, der zwischen die zweite Leitung 207 und einen Anschluß 4071 gekoppelt ist.

Im folgenden wird die Funktionsweise des in Fig. 4 dargestellten ROM-Speichers erklärt.

Zum Auslesen des in der ersten Speicherzelle 201 gespeicherten ersten Speicherzustands sind in dem in Fig. 4 dargestellten Ausführungsbeispiel die Schalter 2111, 2131 sowie der Schalter 2115 geschlossen. Da durch das Schließen des Schalters 2111 das Bitleitungslesepotential auf die erste Bitleitung 205 gelegt worden ist und durch das Schließen des Schalters 2131 auf die zweite Bitleitung 207 das Referenzpotential gelegt worden ist, bildet sich ein Stromfluß durch die Speicherzelle 201 aus, wenn das Referenzpotential niedriger als das Bitleitungslesepotential ist und wenn der Speichertransistor 2011 beispielsweise ein n-Kanal-Feldeffekttransistor ist, da durch das Schließen des Schalters 2115 das Wortleitungslesepotential auf die Wortleitung 209 gelegt wird, wodurch der Transistor 2011 eingeschaltet wird. Wird der Schalter 2113 geschlossen, so kann über den Anschluß 21131 das bezüglich des Bitleitungslesepotentials veränderte Potential abgegriffen werden, wodurch der erste Zustand der ersten Speicherzelle 201 nun ausgelesen werden kann.

Zum Auslesen des in diesem Ausführungsbeispiel programmierten zweiten Zustands in der Speicherzelle 203 wird der Schalter 2111 geöffnet, wodurch die erste Bitleitung 205 von dem Bitleitungslesepotential getrennt wird. Gleichzeitig wird zum Legen des Bitleitungslesepotentials auf die zweite Bitleitung 207 der Schalter 405 geschlossen und der Schalter 2131 der Einrichtung 213 zum Legen der zweiten Bitleitung 207 auf das Referenzpotential wird geöffnet, so daß die zweite Bitleitung 207 nun mit dem Bitleitungslesepotential und nicht mehr mit dem Referenzpotential beaufschlagt ist. Zum Auslesen des in der zweiten Speicherzelle 203 gespeicherten zweiten Zustands wird dann der Schalter 4031, an dessen Anschluß 40311 das Referenzpotential anlegbar ist, geschlossen, so daß auf der weiteren Bitleitung 401 das Referenzpotential anliegt. Da der Steueranschluß 20315 des Speichertransistors 2031 mit der weiteren Bitleitung 401 gekoppelt ist, so kann die zweite Bitleitung 207 nicht über die zweite Speicherzelle 203 in Richtung des Referenzpotentials, beispielsweise Massepotentials, entladen werden. Da ferner die erste Bitleitung 205 mittels des nun geöffneten Schalters 2111 von dem Bitleitungslesepotential getrennt ist, kann auch die erste Bitleitung 205 trotz des eingeschalteten Transistors 2011 nicht zu einer Entladung der zweiten Bitleitung 207 beitragen, so daß das sich auf der zweiten Bitleitung 207 einstellende Potential bezüglich des Bitleitungslesepotentials stabil und nicht verändert ist und in einem Idealfall dem Bitleitungslesepotential entspricht.

Wurde in dem in Fig. 4 dargestellten Ausführungsbeispiel in der zweiten Speicherzelle 203 beispielsweise der erste Zustand durch eine Verbindung des Steueranschlusses 20315 mit der Wortleitung 209 und nicht mit der weiteren Bitleitung 401 programmiert, so würde sich zwischen der zweiten Bitleitung 207, da sie mit dem Bitleitungslesepotential beaufschlagt ist, und der weiteren Bitleitung 401 über den Transistor 2031 ein Stromfluß ausbilden, so daß sich auf der zweiten Bitleitung 207 ein bezüglich des Bitleitungslesepotentials verändertes Potential einstellen würde.

Zum Auslesen des sich auf der zweiten Bitleitung 207 einstellenden Potentials unabhängig von dem in der zweiten Speicherzelle 203 programmierten Zustands der Schalter 407 geschlossen werden, so daß an dessen Anschluß 4071 der Zustand in der zweiten Speicherzelle 203 ausgelesen werden kann.

In dem in Fig. 4 dargestellten Ausführungsbeispiel werden die Schalter 2111, 405, 2131 und 4031 gemeinsam betätigt, wie es durch die eingezeichnete Verbindung zwischen den jeweiligen Steueranschlüssen verdeutlicht ist. Zum Steuern der Schalter kann, wie es bereits im Zusammenhang mit den in Fig. 2 und 3 dargestellten Ausführungsbeispielen bereits beschrieben worden ist, das Ansteuersignal verwendet werden. Dabei ist es jedoch nicht zwingend notwendig, daß die Schalter 2111, 405, 2131 und 4031 gemeinsam betätigt werden. Denkbar ist es ebenfalls, daß beispielsweise zum Auslesen des in der ersten Speicherzelle 201 gespeicherten Zustands zunächst der Schalter 2111 angesteuert wird, wodurch auf die erste Bitleitung 205 das Bitleitungslesepotential gelegt wird. Danach wird der Schalter 2131 geschlossen, so daß die zweite Bitleitung 207 mit dem Referenzpotential beaufschlagt ist und die erste Bitleitung 205 sich über den Transistor 2011 in Richtung des Referenzpotentials entlädt. Während dessen bleiben die Schalter 4031 und 405 geöffnet, um zu gewährleisten, daß die zweite Bitleitung 207 mit dem Referenzpotential und nicht mit dem Bitleitungslesepotential beaufschlagt wird. Analog wird zum Auslesen des in der zweiten Speicherzelle gespeicherten Zustands die Schalter 2111 und 21311 wieder geöffnet, um die erste Bitleitung 205 von dem Bitleitungslesepotential und um die zweite Bitleitung 207 von dem Referenzpotential zu trennen. Danach können die Schalter 405 und 4031 angesteuert werden, um die zweite Bitleitung 207 auf das Bitleitungslesepotential und um die weitere Bitleitung 401 auf das Referenzpotential zu legen.

In beiden diskutierten Fällen ist die Einrichtung zum Auslesen 211 ausgebildet, um zum Auslesen der zweiten Speicherzelle 203 die erste Bitleitung 205 von dem Bitleitungslesepotential oder auch von dem Referenzpotential, das möglicherweise auf der ersten Bitleitung 205 anliegt, abzutrennen. Die Einrichtung zum Auslesen 211 ist ferner ausgebildet, um die weitere Einrichtung 403 zum Legen der weiteren Bitleitung auf das Referenzpotential zu deaktivieren, um zu verhindern, daß bei dem Auslesen der ersten Speicherzelle 201 sich ein weiterer Stromfluß über die zweite Speicherzelle 203 ausbildet, falls in der zweiten Speicherzelle 203 der zweite Zustand einprogrammiert ist.

In dem in Fig. 4 dargestellten Ausführungsbeispiel werden zum Aktivieren der jeweiligen Bitleitung sowie zum Aktivieren der Wortleitung 209 jeweils gesteuerte Schalter eingesetzt. An dieser Stelle sei jedoch darauf hingewiesen, daß dieser Schalter, wie es bereits im Zusammenhang mit den in Fig. 2 und 3 dargestellten Ausführungsbeispielen bereits beschrieben worden ist, beispielsweise durch eine gesteuerte Spannungs- oder eine weitere Referenzquelle ersetzt sind.

Die Funktionsweise des in Fig. 4 dargestellten Ausführungsbeispiels des erfindungsgemäßen ROM-Speichers wurde für den Fall diskutiert, daß die Speichertransistoren 2011 und 2031 als n-Kanal-Feldeffekttransistoren ausgebildet sind. An dieser Stelle sei jedoch darauf hingewiesen, daß die Speichertransistoren 2011 und 2031 ebenso als p-Kanal-Feldeffekttransistoren oder auch als Bipolartransistoren ausgeführt sein können.

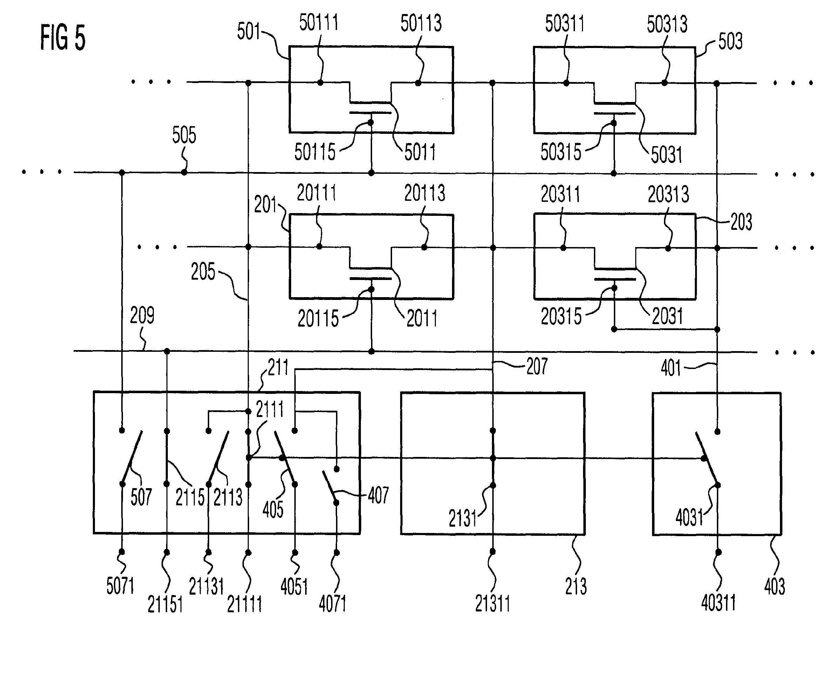

In Fig. 5 ist ein viertes Ausführungsbeispiel des erfindungsgemäßen ROM-Speichers dargestellt. Zusätzlich zu dem in Fig. 4 dargestellten ROM-Speicher umfaßt der in Fig. 5 gezeigte Speicher eine dritte Speicherzelle 501 und eine vierte Speicherzelle 503. Die dritte Speicherzelle 501 umfaßt ferner einen Speichertransistor 5011 mit einem erste Leitungsanschluß 50111, einem zweiten Leitungsanschluß 50113 und einem Steueranschluß 50115. Die vierte Speicherzelle 503 umfaßt einen Speichertransistor 5031 mit einem ersten Leitungsanschluß 50311, einem zweiten Leitungsanschluß 50313 und einem Steueranschluß 50315. Der erste Leitungsanschluß 50111 der dritten Speicherzelle 501 ist mit der ersten Bitleitung 205 gekoppelt, der zweite Leitungsanschluß 50113 der dritten Speicherzelle 501 ist mit der zweiten Bitleitung 207 gekoppelt. Der erste Leitungsanschluß 50311 der vierten Speicherzelle 503 ist ebenfalls mit der zweiten Bitleitung 207 gekoppelt, der zweite Leitungsanschluß 50313 der vierten Speicherzelle 503 ist hingegen mit der weiteren Bitleitung 401 gekoppelt. Der in Fig. 5 dargestellte ROM-Speicher umfaßt ferner eine weitere Wortleitung 505. Der Steueranschluß 50115 des Speichertransistors 5011 ist mit der weiteren Wortleitung 505 gekoppelt, so daß in der dritten Speicherzelle 501 der erste Speicherzustand programmiert ist. Der Steueranschluß 50315 der vierten Speicherzelle 503 ist in diesem Ausführungsbeispiel ebenfalls mit der weiteren Wortleitung 505 gekoppelt, so daß auch in der vierten Speicherzelle 503 der erste Zustand programmiert ist. Die Einrichtung 211 zum Legen weist ferner einen Schalter 507 auf, der zwischen die weitere Bitleitung 505 und einen Anschluß 5071 gekoppelt ist.

Im folgenden wird die Funktionsweise des in Fig. 5 dargestellten Ausführungsbeispiels des erfindungsgemäßen ROM-Speichers erläutert.

Wie es im Zusammenhang mit dem in Fig. 4 dargestellten Ausführungsbeispiel des erfindungsgemäßen ROM-Speichers bereits diskutiert worden ist, wird zum Auslesen der ersten Speicherzelle 201 zunächst auf die Wortleitung 209 das Wortleitungslesepotential gelegt, indem der Schalter 2115, an dessen Anschluß 21151 das Wortleitungslesepotential anlegbar ist, geschlossen wird. Dadurch ist der Speichertransistor 2011, der in diesem Ausführungsbeispiel als ein n-Kanal-Feldeffekttransistor ausgeführt ist, aktiviert. Wird der Schalter 2111, wie es in diesem Ausführungsbeispiel gezeigt ist, geschlossen, so wird auf die erste Bitleitung 205 das Bitleitungslesepotential gelegt, das an den Anschluß 21111 anlegbar ist. Zum Auslesen des in der ersten Speicherzelle 201 gespeicherten ersten Speicherzustands wird die zweite Bitleitung 207 mit dem Referenzpotential beaufschlagt, indem der Schalter 2131 geschlossen wird. Dabei bleiben die Schalter 405 und 4031 geöffnet, um zu verhindern, daß die zweite Bitleitung 207 mit den Bitleitungslesepotential beaufschlagt wird und daß die weitere Bitleitung 401 mit dem Referenzpotential beaufschlagt wird.

Wird der Schalter 2113 nun geschlossen, so kann über den Anschluß 21131 das sich auf der ersten Bitleitung 205 einstellende Potential, das in diesem Ausführungsbeispiel das bezüglich des Bitleitungslesepotentials veränderte Potential ist, abgegriffen werden. Bleibt während dessen der Schalter 507 geöffnet, so wird die weitere Bitleitung 505 nicht mit dem Wortleitungslesepotential beaufschlagt, so daß die Transistoren 5011 und 5031 nicht eingeschaltet werden. Zum Auslesen des in der ersten Speicherzelle 201 gespeicherten ersten Zustands wird die erste Bitleitung 205 daher nur über die erste Speicherzelle 201 in Richtung der zweiten Bitleitung 207 entladen. Da die weitere Bitleitung 401 von dem Referenzpotential getrennt ist, weil der Schalter 4031 geöffnet ist, und da die Speichertransistoren 5011 und 5031 ausgeschaltet sind, kann die erste Bitleitung 205 weder über die dritte Speicherzelle 501 noch über die vierte Speicherzelle 503 entladen werden. Die Entladung der ersten Bitleitung 205 kann auch nicht über die zweite Speicherzelle 203 erfolgen, da einerseits der Schalter 4031 geöffnet ist und andererseits der Speichertransistor 2031 zum Speichern des zweiten Zustands ausgeschaltet ist, indem der Steueranschluß 20315 des Speichertransistors 2031 mit der weiteren Bitleitung 401 verbunden ist.

Zum Auslesen des in der dritten Speicherzelle 501 gespeicherten ersten Zustands wird beispielsweise der Schalter 2115 wieder geöffnet, so daß die Wortleitung 209 wieder von dem Wortleitungslesepotential getrennt wird, und der Schalter 507 wird geschlossen, um die weitere Wortleitung 505 auf das Wortleitungslesepotential zu legen. Dadurch wird der Speichertransistor 5011, der in diesem Ausführungsbeispiel als ein n-Kanal-Feldeffekttransistor ausgeführt ist, eingeschaltet und die erste Bitleitung 205 über die dritte Speicherzelle 501 entladen. Durch Schließen des Schalters 2113 kann an dem Anschluß 21131 erneut das sich auf der ersten Bitleitung 205 einstellende Potential ausgelesen werden, das in diesem Ausführungsbeispiel das bezüglich des Bitleitungslesepotentials veränderte Potential ist, da in der dritten Speicherzelle 501 der erste Zustand gespeichert ist. Da der Speichertransistor 2011 der ersten Speicherzelle 201 nicht eingeschaltet ist, weil die Wortleitung 209 nicht aktiv ist, kann sich die erste Bitleitung 205 nicht über die erste Speicherzelle 201 in Richtung der zweiten Bitleitung 207 entladen. Obwohl der Speichertransistor 5031, der in diesem Ausführungsbeispiel ein n-Kanal-Feldeffekttransistor ist, aktiviert ist, kann sich über die vierte Speicherzelle 503 kein Stromfluß ausbilden, da der Schalter 4031 geöffnet ist und die weitere Bitleitung 401 von dem Referenzpotential getrennt ist. Da die zweite Speicherzelle 203 ausgeschaltet ist, kann sich auch über die zweite Speicherzelle 203 kein Stromfluß in Richtung der weiteren Bitleitung 401 ausbilden. Selbst wenn in der zweiten Speicherzelle 203 der erste Zustand programmiert wäre, würde sich dennoch kein Stromfluß durch die zweite Speicherzelle 203 ausbilden, da, wie bereits erwähnt, der Schalter 4031 geöffnet und die weitere Bitleitung 401 von dem Referenzpotential getrennt ist.

Zum Auslesen des in der vierten Speicherzelle 503 gespeicherten ersten Zustands wird nun die zweite Bitleitung 207 durch Öffnen des Schalters 2131 von dem Referenzpotential getrennt und durch Schließen des Schalters 405 mit dem Bitleitungslesepotential beaufschlagt. Gleichzeitig wird der Schalter 4031 geschlossen, um auf die weitere Bitleitung 401 das Referenzpotential zu legen. Dabei wird der Schalter 2111 geöffnet, um die erste Bitleitung 205 von dem Bitleitungslesepotential zu trennen. Wird ferner die Wortleitung 209 von dem Wortleitungslesepotential durch Öffnen des Schalters 2115 getrennt und wird die weitere Wortleitung 505 durch Schließen des Schalters 507 mit dem Wortleitungslesepotential beaufschlagt, so wird der Speichertransistor 5031, der in diesem Ausführungsbeispiel als ein n-Kanal-Feldeffekttransistor ausgeführt ist, aktiviert, und die zweite Bitleitung 207 wird über die vierte Speicherzelle 503 in Richtung der weiteren Bitleitung 401 entladen. Dabei stellt sich auf der zweiten Bitleitung 207 das bezüglich des Wortleitungslesepotentials veränderte Potential ein, das beispielsweise durch Schließen des Schalters 407 über den Anschluß 4071 ausgelesen werden kann. Dabei wird die zweite Bitleitung 207 nur über die vierte Speicherzelle 503 entladen, da über die anderen Speichertransistoren sich gemäß diesem Ausführungsbeispiel kein Stromfluß ausbilden kann.

Der in Fig. 5 dargestellte erfindungsgemäße ROM-Speicher umfaßt ein Array von vier Speichertransistoren 201, 203, 501 und 503. Dabei bilden die Speicherzellen 201 und 203 beispielsweise eine erste Zeile des Arrays und die Speicherzellen 501 und 503 eine zweite Zeile des Arrays. Analog bilden die Speicherzellen 201 und 501 beispielsweise eine erste Spalte des Arrays und die Speicherzellen 203 und 503 eine zweite Spalte des Arrays. Zum Auslesen der in der ersten Spalte des Arrays gespeicherten Zustände wird zunächst die Wortleitung 209 aktiviert, indem sie mit dem Wortleitungslesepotential beaufschlagt wird. Zum Auslesen der ersten Speicherzelle 201 wird dann auf die erste Bitleitung 205 das Bitleitungslesepotential gelegt und auf die zweite Bitleitung 207 wird das Referenzpotential gelegt. Nachdem der in der ersten Speicherzelle gespeicherte Zustand ausgelesen worden ist, kann der in der zweiten Speicherzelle 203 gespeicherte Speicherzustand ausgelesen werden. Dazu wird die erste Bitleitung 205 wieder von dem Bitleitungslesepotential getrennt und es wird auf die zweite Bitleitung 207 das Bitleitungslesepotential gelegt. Dabei wird auf die weitere Bitleitung 401 das Referenzpotential gelegt, so daß der Speicherzustand in der zweiten Speicherzelle ausgelesen werden kann.

Analog können die Speicherzustände, die in der zweiten Spalte des Arrays gespeichert sind, ausgelesen werden. Dabei wird die Wortleitung 209 wieder von dem Bitleitungslesepotential getrennt und es wird auf die Wortleitung 505 das Wortleitungslesepotential gelegt. Durch Aktivierung der ersten Bitleitung 205 und durch Legung der zweiten Bitleitung 207 auf das Referenzpotential kann nun der in der dritten Speicherzelle 501 eingespeicherte Zustand ausgelesen werden. Zum Auslesen des in der vierten Speicherzelle 503 gespeicherten Zustands wird nun die erste Bitleitung 205 erneut von dem Bitleitungslesepotential getrennt und es wird auf die zweite Bitleitung 207 das Bitleitungslesepotential gelegt, und die weitere Bitleitung 401 wird mit dem Referenzpotential beaufschlagt. Dabei kann die Reihenfolge des Auslesens natürlich umgedreht werden, so daß in der ersten Spalte zunächst die Speicherzelle 203 und dann die Speicherzelle 201 ausgelesen wird. Analog kann in der zweiten Spalte zunächst die Speicherzelle 503 und dann die Speicherzelle 501 ausgelesen werden.

Zum Aktivieren der jeweiligen Zeile wird in dem in Fig. 5 dargestellten Ausführungsbeispiel entweder die Wortleitung 209 oder die weitere Wortleitung 505 durch Legen des Bitleitungslesepotentials auf die jeweilige Wortleitung aktiviert.

Da bei einem Lesezugriff auf die jeweilige Bitleitung in Abhängigkeit von der in der auszulesenden Speicherzelle die Bitleitung entladen werden kann, müssen die Bitleitungen zwischen einem ersten und einem zweiten Lesezugriff mit dem Bitleitungslesepotential beaufschlagt werden, um die Bitleitungen aufzuladen, so daß sich bei dem jeweiligen Lesezugriff ein stationärer Anfangszustand einstellt. Dadurch wird verhindert, daß bei dem Lesezugriff die der jeweiligen Bitleitung stets anhaftenden internen parasitären Kapazitäten erst bei dem Lesezugriff umgeladen werden. Dies kann dadurch realisiert werden, daß die Einrichtung 211 zum Auslesen beispielsweise einen vierten Schalter aufweist, der in Fig. 5 nicht eingezeichnet ist, der beispielsweise zwischen die erste Bitleitung und das Bitleitungslesepotential gekoppelt ist. Wird dieser Schalter zwischen dem ersten und dem zweiten Lesezugriff einem Ladesignal angesteuert, so kann beispielsweise die erste Bitleitung zwischen den jeweiligen Zugriffen auf das Bitleitungslesepotential gelegt werden, um ein stabiles Energieniveau zu erreichen. Dementsprechend kann die Einrichtung 211 zum Auslesen weitere Schalter aufweisen, die die zweite Bitleitung 207 und die weitere Bitleitung 401 zwischen den Lesezugriffen mit dem Bitleitungslesepotential beaufschlagt.

Zum Detektieren der sich auf der jeweiligen Bitleitung einstellenden Potentials in Abhängigkeit von dem in der auszulesenden Speicherzelle programmierten Zustands können die Anschlüsse 21131 und 4071, über die jeweils das sich auf der ersten Bitleitung 205 oder auf der zweiten Bitleitung 207 einstellende Potential abgegriffen werden kann, können diese Anschlüsse mit einem Sensorverstärker, der in Fig. 5 nicht eingezeichnet ist, gekoppelt sein. In diesem Fall ist beispielsweise der zweite Schalter 2113 zwischen die erste Bitleitung 205 und den Sensorverstärker gekoppelt. Wird nun der Schalter 2113 zum Auslesen von beispielsweise des in der ersten Speicherzelle 201 gespeicherten Zustands geschlossen, so kann sich das auf der ersten Bitleitung 205 einstellende Potential, also beispielsweise das bezüglich des Bitleitungslesepotentials veränderte Potential, falls, wie in diesem Ausführungsbeispiel eingezeichnet, der erste Zustand in der Speicherzelle 201 programmiert ist, von dem Sensorverstärker erfaßt bzw. detektiert werden.

Wie bereits erwähnt, kann das Ansteuern der jeweiligen Schalter zum Auslesen der jeweiligen Bitleitung durch ein Ansteuersignal bewerkstelligt werden. Hierzu kann der erfindungsgemäße ROM-Speicher ferner beispielsweise einen steuerbaren Bitleitungsadreßdecoder aufweisen, der in dem in Fig. 5 dargestellten Ausführungsbeispiel nicht eingezeichnet ist. Wird beispielsweise der in der ersten Speicherzelle 201 eingespeicherte Zustand ausgelesen, so kann der Bitleitungsadreßdecoder zunächst beispielsweise ein Adreßsignal empfangen, das der ersten Bitleitung 201 zugeordnet ist. Nachdem der Bitleitungsadreßdecoder das Adreßsignal empfangen hat, liefert er das Ansteuersignal zum Schalter 2111, der daraufhin geschlossen wird, wodurch die erste Bitleitung 205 auf das Bitleitungslesepotential gelegt wird. Gleichzeitig bewirkt das Ansteuersignal, daß die zweite Bitleitung 207 mit dem Referenzpotential beaufschlagt und somit beispielsweise zu einer Groundleitung wird. Das Ansteuersignal kann ferner bewirken, daß der Schalter 2113 zum Auslesen oder Detektieren des sich auf der ersten Bitleitung 205 einstellenden Potentials geschlossen wird. Aufgrund des Ansteuersignals wird der Schalter 4031 geöffnet, so daß die weitere Bitleitung 401 von dem Referenzpotential getrennt wird. Zum Auslesen des beispielsweise in der zweiten Speicherzelle 203 programmierten Speicherzustands empfängt der Bitleitungsadreßdecoder das Adreßsignal, das der zweiten Bitleitung 207 zugeordnet ist. In diesem Fall wird die erste Bitleitung 205 von dem Bitleitungslesepotential getrennt und es wird auf die zweite Bitleitung 207 mit Hilfe des Schalters 405 das Bitleitungslesepotential gelegt. Gleichzeitig wird durch das Ansteuersignal der Schalter 2131 geöffnet, so daß die zweite Bitleitung 207 von dem Referenzpotential getrennt wird. Das Ansteuersignal bewirkt ferner, daß der Schalter 4031 der weiteren Einrichtung 403 zum Legen der weiteren Bitleitung 401 auf das Referenzpotential geschlossen wird.

Zum Ansteuern der jeweiligen Wortleitung kann die Einrichtung 211 zum Auslesen ferner einen Wortleitungsadreßdecoder aufweisen, der ausgebildet ist, um die jeweilige Wortleitung auf das Wortleitungslesepotential zu legen, um die Speichertransistoren in der jeweiligen Spalte des Arrays zu aktivieren oder um die jeweilige Wortleitung von dem Wortleitungslesepotential zu trennen, um die jeweiligen Speichertransistoren der jeweiligen Spalte des Arrays wieder zu deaktivieren. Beispielsweise kann der Wortleitungsadreßdecoder, ähnlich wie es bei dem Bitleitungsadreßdecoder der Fall ist, ein Adreßsignal empfangen, das der jeweiligen Wortleitung zugeordnet ist. Wird beispielsweise das Adreßsignal empfangen, das die Wortleitung 209 adressiert, so wird der Schalter 2115 geschlossen, um die Wortleitung 209 auf das Wortleitungslesepotential zu legen, und der Schalter 507 wird geöffnet oder er bleibt geöffnet, um die Wortleitung 505 von dem Wortleitungslesepotential zu trennen.

In dem in Fig. 5 dargestellten Ausführungsbeispiel umfaßt der erfindungsgemäße ROM-Speicher vier Speichertransistoren, drei Bitleitungen sowie drei Wortleitungen. An dieser Stelle sei jedoch darauf hingewiesen, daß das Array eine beliebige Anzahl von Speichertransistoren, Wortleitungen und Bitleitungen umfassen kann. In diesem Fall kann einer jeden Bitleitung beispielsweise eine Einrichtung zum Legen der jeweiligen Bitleitung auf das Referenzpotential zugeordnet sein, wie dies in Fig. 5 bereits für die zweite Bitleitung 207 und für die weitere Bitleitung 401 der Fall ist. Des weiteren wird in diesem Fall die Einrichtung 211 zum Auslesen derart ausgebildet sein, um diejenige Bitleitung zu aktivieren, d. h. auf das Bitleitungslesepotential zu legen, die ausgelesen sein soll. Dabei kann der Bitleitungsadreßdecoder eine Mehrzahl von Adreßsignalen empfangen, wobei jedes dieser Adreßsignale einer Bitleitung zugeordnet ist. Analog ist der Wortleitungsadreßdecoder ausgebildet, um eine Mehrzahl von Adressen bzw. von Adreßsignalen zu empfangen, wobei jedem Adreßsignal eine Wortleitung zum Aktivieren zugeordnet ist.

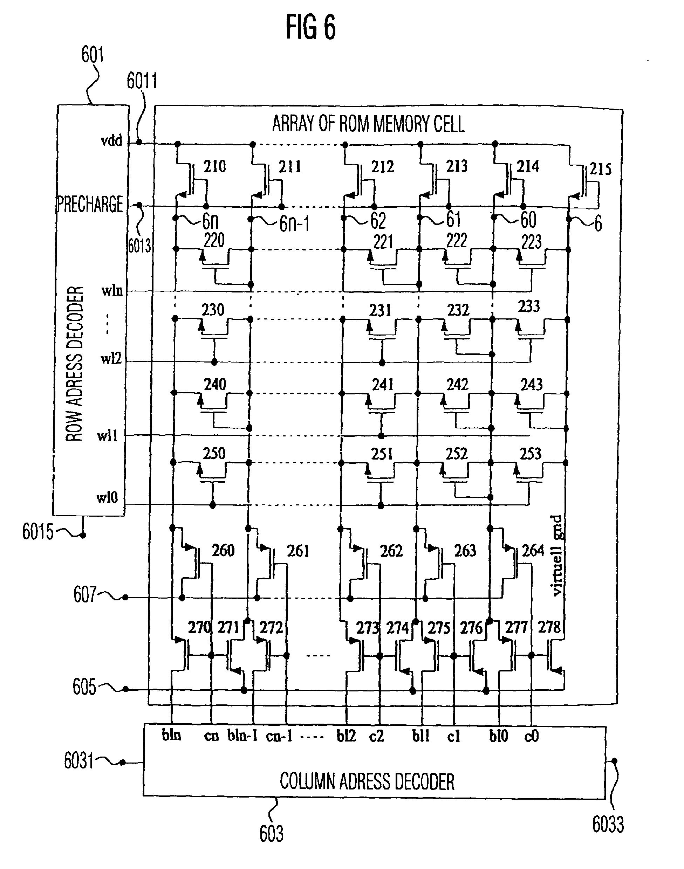

In Fig. 6 ist ein fünftes Ausführungsbeispiel des erfindungsgemäßen ROM-Speichers gemäß der vorliegenden Erfindung dargestellt.

Der erfindungsgemäße ROM-Speicher ist in dem in Fig. 6 gezeigten Ausführungsbeispiel in Form eines Arrays von ROM-Speicherzellen (array of ROM memory cell) aufgebaut. Der ROM-Speicher umfaßt zunächst eine Mehrzahl von Bitleitungen b, b10 - b1n und eine Mehrzahl von Wortleitungen w10 - wln. Darüber hinaus weist der ROM-Speicher eine Mehrzahl von Speichertransistoren 220 - 253 auf. Die Speichertransistoren, die die jeweilige Spalte des Arrays bilden, sind jeweils zwischen zwei benachbarten Bitleitungen gekoppelt. Die Steueranschlüsse der Speichertransistoren, die in der jeweiligen Spalte des Arrays angeordnet sind, sind entweder mit der jeweiligen Wortleitung, die der jeweiligen Spalte zugeordnet sind, verbunden, wodurch jeweils der erste Speicherzustand realisiert wird oder die Steueranschlüsse der jeweiligen Speichertransistoren sind mit der jeweiligen Bitleitung verbunden, die jeweils rechts von dem jeweiligen Speichertransistor angeordnet ist, um den zweiten Zustand zu speichern.

Der in Fig. 6 dargestellte ROM-Speicher umfaßt ferner einen Zeilenadreßdecoder (row address decoder) 601. Der Zeilenadreßdecoder 601 weist zunächst eine Mehrzahl von Ausgängen auf, wobei jeder der Ausgänge mit einer der Wortleitungen w10 - wln gekoppelt ist. Der Zeilenadreßdecoder weist ferner einen ersten weiteren Ausgang 6011 und einen zweiten weiteren Ausgang 6013 auf.

Darüber hinaus weist der ROM-Speicher eine Mehrzahl von Transistoren 210 - 215, wobei jeder der Transistoren 210 - 215 jeweils zwischen die jeweilige Bitleitung b, b10 - b1n und den ersten weiteren Ausgang 6011 des Zeilenadreßdecoders 601 gekoppelt ist. Die Steueranschlüsse der Transistoren 210 - 215 sind jeweils mit dem zweiten weiteren Ausgang 6013 des Zeilenadreßdecoders 601 verbunden. Darüber hinaus weist der Zeilenadreßdecoder einen Zeilensteuereingang 6015 auf. Der in Fig. 6 dargestellte ROM-Speicher umfaßt ferner einen Spaltenadreßdecoder (column address decoder) 603.

Der Spaltenadreßdecoder 603 (Bitleitungsadreßdecoder) weist einen Spaltenadreßeingang 6031 und einen Ausgang 6033 auf. Der Spaltenadreßdecoder 603 umfaßt ferner eine Mehrzahl von Bitleitungsanschlüssen b, b10 - b1n sowie eine Mehrzahl von Ansteueranschlüssen c0 - cn.

Darüber hinaus umfaßt der ROM-Speicher eine Mehrzahl von ersten Transistoren 270, 272, 273, 275, 277, die jeweils zwischen die jeweilige Bitleitung b0 - bn und den jeweiligen Bitleitungsanschluß b10 - b1n des Spaltenadreßdecoders 603 gekoppelt sind. Die Steueranschlüsse der Mehrzahl der ersten Transistoren sind jeweils mit dem jeweiligen Steueranschluß c0 - cn gekoppelt. Der ROM-Speicher umfaßt ferner eine Mehrzahl von zweiten Transistoren 271, 274, 276 und 278. Die jeweiligen Transistoren der Mehrzahl der zweiten Transistoren sind jeweils zwischen eine der Bitleitungen b - bn-1 und einen Anschluß 605, an den ein Potential anlegbar ist, gekoppelt.

Der in Fig. 6 dargestellte ROM-Speicher umfaßt ferner eine Mehrzahl von weiteren Transistoren 260 - 264, die jeweils mit einer der Bitleitungen b0 - bn und einem weiteren Anschluß 607, an den ein Potential größer als das Referenzpotential, z.B. vdd, anlegbar ist, gekoppelt sind. Sowohl die Steueranschlüsse der weiteren Transistoren 260 - 264 als auch die Steueranschlüsse der Mehrzahl der zweiten Transistoren 271, 274, 276, 278 sind mit den Ansteueranschlüssen c0 - cn des Spaltenadreßdecoders 603 gekoppelt.

Zum Auslesen der jeweiligen Bitleitung kann das sich auf der jeweiligen Bitleitung einstellende Potential von dem bereits erwähnten Sensorverstärker detektiert werden. Dabei wird auf der Basis eines Vergleichs zwischen einem Vergleichspotential und beispielsweise dem Potential auf der ersten Bitleitung ein Detektionssignal geliefert, das den ersten oder den zweiten Zustand in beispielsweise der ersten Speicherzelle anzeigt.

Im folgenden wird die Funktionsweise des in Fig. 6 dargestellten erfindungsgemäßen ROM-Speichers erklärt.

In dem in Fig. 6 dargestellten Ausführungsbeispiel des erfindungsgemäßen ROM-Speichers sind die Speichertransistoren 220 - 253 als selbstsperrende n-Kanal-Feldeffekttransistoren ausgeführt. Darüber hinaus sind die ersten, zweiten und die weiteren Transistoren als selbstsperrende p-Kanal-Feldeffekttransistoren ausgeführt. Zum Auslesen des in dem Speichertransistor 251 empfängt der Zeilenadreßdecoder 601 über den Zeilenadreßeingang 6015 ein Adreßsignal, das der Wortleitung w10 zugeordnet ist. Dadurch wird auf die Wortleitung w10 das Wortleitungsaktivierungspotential gelegt und der Speichertransistor 251 wird eingeschaltet. Zum Auslesen des in dem Speichertransistor 251 gespeicherten Zustands wird an den Ansteueranschluß c2 ein Ansteuersignal gelegt, das die Transistoren 273, 247 und 262 aktiviert, d. h. einschaltet. Da diese Transistoren als p-Kanal-Feldeffekttransistoren ausgeführt sind, entspricht das Ansteuersignal einem "Low". Wird an den Anschluß 607 ein Potential gelegt, das das Bitleitungslesepotential bestimmt, so wird die Bitleitung b2 mit dem Bitleitungslesepotential beaufschlagt, da der Transistor 262 leitend ist. Wird darüber hinaus an den Anschluß 605 ein Potential gelegt, das das Referenzpotential bestimmt, so wird die rechts von der Bitleitung b2 liegende Bitleitung b1 mit dem Referenzpotential beaufschlagt, wenn an dem Ansteueranschluß c1 ein "High" anliegt, d. h. wenn z.B. an den Ansteueranschluß c1 das Ansteuersignal nicht gelegt wird. In diesem Fall sind die Transistoren 263, 275 und 276 gesperrt.

Wird an den Anschluß 605 das gegen Masse gehende Massepotential gelegt, so wird die Bitleitung b1 zur Groundleitung, und die Bitleitung b2 wird über den Transistor 251 in Richtung b1 entladen. Aufgrund dieser Entladung stellt sich auf der Bitleitung b2 ein Potential ein, das bezüglich des Bitleitungslesepotentials verändert ist. In anderen Worten ausgedrückt, wird das Potential der Bitleitung b2 "in Richtung Referenzpotential gezogen", da das Bitleitungslesepotential größer als das Referenzpotential 605 ist. Da an dem Ansteueranschluß c2 das Ansteuersignal anliegt, ist auch der Transistor 273 leitend, so daß über den Bitleitungsanschluß b12 das bezüglich des Bitleitungslesepotentials veränderte Potential abgegriffen werden kann, wodurch der in dem Transistor 251 gespeicherte erste Zustand ausgelesen werden kann. Der Spaltenadreßdecoder 603 ist ausgebildet, so daß das bezüglich des Bitleitungslesepotentials veränderte Potential an dem Ausgang 6033 anliegt und dort ausgelesen werden kann. Die Bitleitung b2 wird also nur über den Transistor 251 entladen, da die Wortleitungen w11 - wln nicht mit dem Wortleitungslesepotential beaufschlagt sind, und die Bitleitung b0 sich in einem Leerlauf befindet, da die Transistoren 276 und 277 gesperrt sind.

Zum Auslesen der Bitleitung b2 wird über den Spaltenadreßeingang 6031 die Bitleitung b2 ausgewählt, d. h., daß das Ansteuersignal nur an den Ansteueranschluß c2 gelegt wird. Die übrigen Ansteueranschlüsse werden während des Auslesens der Bitleitung b2 nicht mit dem Ansteuersignal beaufschlagt, so daß gemäß diesem Ausführungsbeispiel an diesen Anschlüssen z.B. ein "High" anliegt.

Zum Auslesen der Bitleitung b1 wird an den Spaltenadreßeingang 6031 ein Adreßsignal angelegt, das der Bitleitung b1 zugeordnet ist. Dadurch wird an den Ansteueranschluß c1 das Adreßsignal angelegt, das gemäß diesem Ausführungsbeispiel ein "Low" repräsentiert. Alle übrigen Ansteueranschlüsse werden nicht mit dem Ansteuersignal beaufschlagt, so daß an denen ein "High" anliegt.

Durch das Anlegen des Ansteuersignals an den Ansteueranschluß c1 werden die Transistoren 275, 276 und 263 in einen Zustand geschaltet, in dem sie leitend sind. Da an den übrigen Ansteueranschlüssen kein Steuersignal anliegt, sind beispielsweise die Transistoren 274, 273, 262, 277 und 246, gesperrt. Über den Transistor 263 wird auf die Bitleitung b1 das Bitleitungslesepotential hier in Richtung vdd aufgeladen und die Bitleitung b0 wird mit dem Referenzpotential 605 beaufschlagt, sie wird also beispielsweise zur Groundleitung. Zum Auslesen des beispielsweise in dem Transistor 242 gespeicherten Speicherzustands, der gemäß diesem Ausführungsbeispiel der zweite Zustand ist, wird über den Zeilenadreßeingang 6015 die Wortleitung w11 mit dem Wortleitungsaktivierungspotential beaufschlagt, alle übrigen Wortleitungen sind deaktiviert. Da der Transistor 242 aufgrund des in ihm gespeicherten zweiten Zustands ausgeschaltet ist, wird die Bitleitung b1 nicht entladen, so daß sich auf der Bitleitung b1 ein bezüglich des Bitleitungslesepotentials stabiles Potential einstellt, das über den Transistor 275, der eingeschaltet ist, den Bitleitungsanschluß b11 an den Ausgang 6033 weitergeleitet wird.
Zwischen den Lesezugriffen, d. h. in der Zeitspanne, in der das Ansteuersignal an keinem der Ansteueranschlüsse c0 - cn anliegt, werden die Bitleitungen b, b0 - bn mit Hilfe der Schalter 210 - 215 auf das Bitleitungslesepotential gelegt, um die Bitleitungen aufzuladen, damit die Zugriffszeiten verkürzt werden und damit bei dem Auslesen der jeweiligen Bitleitung die Umladeverluste möglichst gering werden. Hierzu liefert der Zeilenadreßdecoder 601 an den ersten weiteren Ausgang 6011 das Potential, das das Bitleitungslesepotential bestimmt. Dieses Potential kann beispielsweise mit Hilfe einer angelegten Spannung vdd erzeugt werden. Wird zwischen den Lesezugriffen von dem Zeilenadreßdecoder 601 an den zweiten weiteren Ausgang 6013 ein Ladesignal (Precharge) geliefert, so werden die Transistoren 210 - 214, da sie gemäß diesem Ausführungsbeispiel als n-Kanal-Transistoren ausgeführt sind, eingeschaltet, und es wird auf die jeweilige Bitleitung b, b0 - bn das Bitleitungslesepotential gelegt.

Erfindungsgemäß werden die in Fig. 6 bezeichneten Speichertransistoren 220 - 253 immer zwischen den Bitleitungen angeschlossen. Pro ROM-Matrix ist zusätzlich nur eine virtuelle Groundleitung erforderlich, die gemäß dem in Fig. 6 dargestellten Ausführungsbeispiel identisch mit der Bitleitung b ist. An die Bitleitung b (Groundleitung) sind die Transistoren 223, 233, 243 und 253 angeschlossen. Die Programmierung des jeweiligen Speicherzustands erfolgt erfindungsgemäß über den Steueranschluß (Gate-Anschluß) der dargestellten Speichertransistoren 220 - 253. Diese werden je nach zu speicherndem Zustand an die Wortleitung w10 - wln oder an die in Richtung virtuellem Ground liegende Bitleitung angeschlossen. Die an die Wortleitung angeschlossenen Transistoren 223, 231, 233, 241, 250, 251, 253 werden bei Auswahl der entsprechenden Wortleitung in den "Ein"-Zustand geschaltet, die an die Bitleitung angeschlossenen Transistoren 220, 221, 232, 240, 242, 243 und 252 sind bei Auswahl der entsprechenden Wortleitung in den "Aus"-Zustand geschaltet. Dieser "Aus"-Zustand unterbricht die Entladung weiterer Bitleitungen, was zu einer Reproduzierung eines Aktivstroms führt.

Des weiteren werden unter der Voraussetzung, daß die "Ein"und "Aus"-Zustände in dem ROM gleich verteilt sind, die kapazitiven Transistorlasten gleichmäßiger auf Bit- und Wortleitung verteilt. Durch die Transistoren 210 - 215 werden die Bitleitungen zwischen den Lesezugriffen auf ein Referenzsignal vdd minus n-Kanal-Schwellenspannung (Bitleitungslesepotential) aufgeladen. Die Auswahl einer aktiven Bitleitung erfolgt durch das Spaltenauswahlsignal (Ansteuersignal) c0 - cn. Es wird dabei immer eine Bitleitung zu einer aktiv gelesenen Bitleitung und direkt davor liegender in Richtung virtuell Ground zum neuen virtuellen Ground. Wird beispielsweise die Bitleitung b10 gelesen, so wird das Spaltenauswahlsignal c0 "low". Der Transistor 278 von einem p-Kanal-Typ entlädt die Leitung mit der Bezeichnung virtuell Ground auf Ground plus p-Kanal-Schwellspannung, die wegen des Body-Effekts betragsmäßig höher liegt als bei einem gegen die Betriebsspannung geschalteten p-Kanal-Transistor. Dementsprechend wird die Bitleitung b10 über den Transistor 277 zu einem Leseverstärker/Komparator oder zu dem bereits erwähnten Phasenstabilitätsdetektor durchgeschaltet. Gleichzeitig lädt der Transistor 264 die Bitleitung b10 gegen die Betriebsspannung auf, wenn z. B. die Wortleitung w11 gleichzeitig mit c0 aktiv wird. Es erfolgt dann über den Transistor 243 keine Entladung der Bitleitung b10, weil dieser Transistor sich in dem "Aus"-Zustand befindet. Das Lesen der Bitleitung b11 erfolgt dann analog mit c1 "low" und b10 wird zum virtuellen Ground. So geht es fort durch alle Bitleitungen der Matrix. Gesperrte Speichertransistoren unterbrechen eine Entladung benachbarter Bitleitungen, die gemäß dem in Fig. 1 dargestellten Stand der Technik stets erfolgt.

Sind auf einer Bitleitung nur "Ein"-Zustände programmiert, so werden benachbarte Bitleitungen nur um einen geringen Pegelhub entladen, der um so geringer wird, um so weiter die nichtausgewählte Bitleitung von der Leitung, die den virtuellen Ground darstellt, entfernt ist, weil die Spannungsdifferenz zwischen Drain und Source der jeweiligen Speichertransistoren ständig abnimmt (Spannungsteiler). Der Aktivstrom wird damit im wesentlichen durch die Anzahl der Bitleitungen bestimmt, die gleichzeitig gelesen werden. Dieser Strom fließt in der Bitleitung b10 bei ausgewählter Wortleitung w10 von vdd über den Transistor 264, 253 und 278 gegen Ground, falls an dem Anschluß 605 das Massepotential liegt.

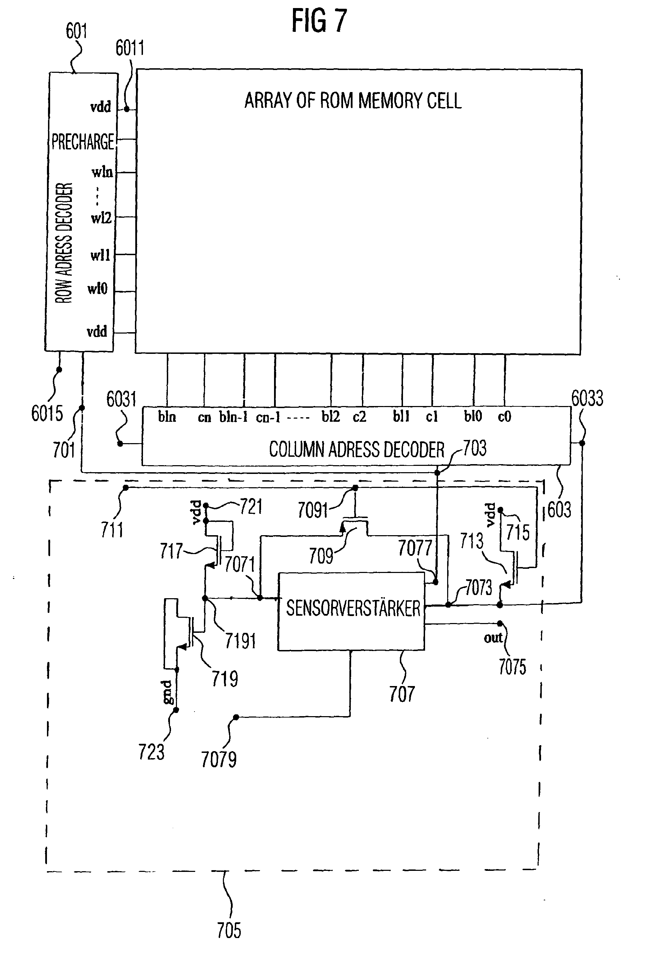

Fig. 7 zeigt ein sechstes Ausführungsbeispiel des ROM-Speichers gemäß der vorliegenden Erfindung. Zusätzlich zu dem in Fig. 6 diskutierten Ausführungsbeispiel weist der Zeilenadreßdecoder 601 einen ersten Aktivierungseingang 701 auf. Der Spaltenadreßdecoder 604 weist ferner einen zweiten Aktivierungseingang 703 auf. Der Aktivierungseingang 701 des Zeilenadreßdecoders 601 ist mit dem Aktivierungseingang des Spaltenadreßdecoders 603 verbunden. Der in Fig. 7 dargestellte ROM-Speicher umfaßt darüber hinaus einen Potentialstabilitätsdetektor 705. Der Potentialstabilitätsdetektor 705 weist zunächst einen Sensorverstärker 707 mit einem ersten Eingang 7071, einem zweiten Eingang 7073, einem weiteren Ausgang 7075 sowie einen Steuerausgang 7077 auf. Zwischen den ersten Eingang 7071 und den zweiten Eingang 7073 ist ein Transistor 709 gekoppelt, wobei ein Steueranschluß 7091 des Transistors 709 mit einem Anschluß 711 gekoppelt ist. Der in Fig. 7 dargestellte ROM-Speicher weist ferner einen Transistor 713 auf, der zwischen den zweiten Eingang 7073 des Sensorverstärkers 707 und einen Anschluß 715 gekoppelt ist.

Der in Fig. 7 dargestellte ROM-Speicher umfaßt ferner einen Transistor 717 und einen Transistor 719. Der Transistor 717 ist zwischen einen Steueranschluß 7191 des Transistors 719 und einen Anschluß 721 gekoppelt. Ein Steueranschluß des Transistors 717 ist ferner mit dem Anschluß 721 gekoppelt, so daß der Transistor 717 als eine Diode geschaltet ist. Die Leitungsanschlüsse des Transistors 719 sind miteinander und mit einem Anschluß 723 verbunden, wobei an den Anschluß 723 beispielsweise das Massepotential, in Fig. 7 mit gnd bezeichnet, anlegbar ist.

Im folgenden wird die Funktionsweise des in Fig. 7 dargestellten ROM-Speichers erklärt.

In Fig. 7 ist eine Ausgestaltung des erfindungsgemäßen ROM-Speichers zusammen mit einem aus der Schaltungstechnik der dynamischen oder statischen Speicher bekannten Leseverstärkers gezeigt. Der Transistor 717 und der Transistor 719, der eine Kapazität darstellt, bilden eine Referenzspannung (Vergleichspotential) für den ersten Eingang 7071 des Sensorverstärkers 707 (Leseverstärker). Wird eine der Bitleitungen zum Auslesen von dem Spaltenadreßdecoder 603 ausgewählt, so liegt die ausgewählte Bitleitung an dem Ausgang 6033 des Spaltenadreßdecoders 603. Über den Transistor 713 wird die zwischen dem Ausgang 6033 und dem zweiten Eingang 7073 ausgebildete Leitung auf das gleiche Potential wie der erste Eingang 7071 des Sensorverstärkers 707 aufgeladen, wenn an den Anschluß 715 das gleiche Potential vdd angelegt wird, das an den Anschluß 721 anlegbar ist. Die Aufladung wird gesteuert über ein Aufladesignal, das an den Anschluß 711 anlegbar ist.

Bis kurz vor einem Anwählen des gewünschten Speichertransistors werden das an dem ersten Eingang 7071 anliegende Referenzsignal und die an dem Ausgang 6033 des Spaltenadreßdecoders 603 durchgeschaltete Bitleitung sowie das sich zwischen dem Ausgang 6033 und dem zweiten Eingang 7073 des Sensorverstärkers 707 befindende Zuleitung über den Transistor 709 kurzgeschlossen, da der Transistor 709 durch das Aufladesignal, das an dem Anschluß 711 anliegt, aktiviert wird. Da die zu lesende, zum zweiten Eingang 7073 des Sensorverstärkers 707 durchgeschaltete Bitleitung entweder aufgeladen oder entladen wird, kann nach einer kurzen Auswahlzeit über den Sensorverstärker 707 der Zustand auf der Bitleitung aufgenommen werden. Nach einer Detektion des sich auf der jeweiligen Bitleitung einstellenden Potentials kann das Detektionssignal über den Ausgang 7075, in dem in Fig. 7 gezeigten Ausführungsbeispiel als OUT bezeichnet, ausgegeben werden. Erfindungsgemäß kann der Sensorverstärker 707 ferner beispielsweise ein Speicherelement aufweisen, um das Detektionssignal bis zu einem nächsten Detektionsvorgang zu speichern.

Alternativ dazu kann an den weiteren Ausgang 7079 beispielsweise das Detektionssignal zur Verfügung gestellt werden, um beispielsweise von einer weiteren Einrichtung, die in Fig. 7 nicht gezeigt ist, zwischengespeichert zu werden. Der Zustand auf der Bitleitung kann somit über ein an dem weiteren Ausgang 7079 geliefertes Latch-Signal gelatcht und der Lesevorgang nach dem Latchen über ein an den Steuerausgang 7073 des Sensorverstärkers 707 geliefertes Steuersignal abgebrochen werden. Dieses Steuersignal liegt dann an dem Steuereingang 701 des Adreßdecoders und bewirkt, daß die jeweilige Wortleitung von dem Wortleitungslesepotential getrennt wird. Dieses Signal unterbricht ferner über den Steuereingang 703 des Spaltenadreßdecoders 603 den jeweiligen Lesevorgang, so daß an die Ansteueranschlüsse c0 - cn kein Ansteuersignal gelegt wird. Das führt zu kurzen Zugriffszeiten und zu einer weiteren Aktivstromeinsparung.

Zur Programmierung des erfindungsgemäßen ROM-Speichers ist es vorteilhaft, eine Kontaktfensterebene sowie eine Metallebene, vorzugsweise eine Kontaktebene von einem Polysilizium zu Metall 1 und beispielsweise eine weitere Metallebene 1 zur Programmierung zu verwenden. Die jeweilige Bitleitung wird dann in einer weiteren Metallebene 3 und die jeweilige Wortleitung in einer Metallebene 2 ausgeführt. Die Größe einer Speicherzelle wird dann nur von den minimalen Entwurfsregeln der verwendeten Technologie zur Herstellung des erfindungsgemäßen ROM-Speichers bestimmt. Dabei kann zur Programmierung eine Maske verwendet werden, die die jeweiligen Verbindungen charakterisiert.

Der erfindungsgemäße maskenprogrammierbare ROM ist derart ausgebildet, daß die Speichertransistoren von beispielsweise einem n-Kanal-Typ zwischen zwei Bitleitungen liegen, von denen die eine in einem Auswahlfall auf ein gegen Ground gehendes Zwischenpotential gezogen wird (virtueller Ground) und die andere beispielsweise von einem Komparator ausgelesen wird. Dabei erfolgt die Auswahl des aktiven virtuellen Grounds und der Bitleitung durch ein low-aktives Spaltensignal paarweise über p-Kanal-Transistoren. Dabei können mindestens vier Speichertransistoren bei einem Kontaktkomplex an eine Bitleitung angeschlossen werden, was zu einer weiteren Flächenersparnis führt. Darüber hinaus werden vor dem Lesen der ausgewählten Speicherstelle die Bitleitungen der Matrix über n-Kanal-Transistoren auf die Betriebsspannung minus n-Kanal-Schwellenspannung vorgeladen, um, wie bereits erwähnt, die Zugriffszeiten zu reduzieren und um die Umladeverluste zu senken.

Zum Auslesen der jeweiligen Bitleitung wird von dem Spaltenadreßdecoder 603 (Spaltendecoder) die ausgewählte Bitleitung über einen p-Typ-Kanal-Transistor in Richtung der Betriebsspannung, beispielsweise vdd, aufgeladen. Dabei wird ein "Low" über den jeweiligen Steueranschluß (Anschluß eines Gates) des jeweiligen Speichertransistors an die Wortleitung programmiert und ein "High" wird über den Anschluß des Gates an die Bitleitung programmiert, die in diesem Falle die Funktion des virtuellen Grounds übernimmt.

Zum Bereitstellen des erfindungsgemäßen maskenprogrammierbaren ROM werden die Bitleitungen beispielsweise in einem dritten Metallisierungsprozeß, die Wortleitungen in einem zweiten Metallisierungsprozeß hergestellt, und die Programmierung wird derart durchgeführt, daß durch ein Herstellen einer Metallverbindung von einer ersten Metallschicht des jeweiligen Steueranschlusses (Gate-Anschlusses) über Kontakte zu der jeweiligen Wortleitung einer zweiten Metallschicht hergestellt werden oder nicht, wobei der Steueranschluß (das Gate) ohne einen Wortleitungsanschluß über eine erste Metallisierungsebene mit der jeweiligen Bitleitung verbunden wird.

Der erfindungsgemäße maskenprogrammierbare ROM zeichnet sich ferner dadurch aus, daß die Referenzspannung (Vergleichspotential) durch eine Aufladung einer Kapazität durch einen n-Kanal-Transistor erzeugt wird. Darüber hinaus entstehen durch Aufladen bzw. durch Entladen der ausgewählten Bitleitungen geringe Pegelhübe, so daß ferner die Verluste minimiert werden. Dadurch, daß die Bitleitungen in einem Vorladefall auf die Referenzspannung aufgeladen werden, erfolgt ein Ladungsausgleich aller Bitleitungen und der Referenzspannung bis kurz vor einem jeweiligen Lesezyklus. Dabei wird der Pegelunterschied zwischen der jeweiligen Bitleitung und der Referenzspannung durch einen Komparator/Sensorverstärker gelesen.

Zum Herstellen des erfindungsgemäßen ROM-Speichers wird zunächst ein Substrat bereitgestellt, wobei das Substrat eine Speicherzelle, einen Speichertransistor mit einem ersten Leitungsanschluß, einem zweiten Leitungsanschluß und einem Steueranschluß aufweist. Dann wird eine ersten Bitleitung 205, eine zweiten Bitleitung 207 sowie eine Wortleitung 209 bereitgestellt. Der erste Leitungsanschluß des Speichertransistors wird mit der ersten Bitleitung 205 verbunden, der zweite Leitungsanschluß des Speichertransistors wird mit der zweiten Bitleitung verbunden. Der Steueranschluß des Speichertransistors wird mit der Wortleitung 209 zum Speichern eines ersten Zustands in der Speicherzelle verbunden oder der Steueranschluß des Speichertransistors wird mit der zweiten Bitleitung zum Speichern eines zweiten Zustands in der Speicherzelle verbunden. Zum Bereitstellen der jeweiligen Bitleitung und der Wortleitung sowie zum Verbinden der jeweiligen Anschlüsse des Speichertransistors wird erfindungsgemäß eine Maske verwendet.

Darüber hinaus ist es denkbar, die Speichertransistoren zum Speichern des ersten Zustands in der Speicherzelle bereitzustellen, wobei die Speichertransistoren zum Speichern des zweiten Zustands nicht bereitgestellt werden.

Ferner wird erfindungsgemäß der Schritt des Schritt des Verbindens des Steueranschlusses des Speichertransistors mit der Wortleitung zum Speichern des ersten Zustands in der Speicherzelle im Kontaktfensterkomplex Alu 1 zu Alu 2 durchgeführt und der Schritt des Verbindens des Steueranschlusses des Speichertransistors mit der zweiten Bitleitung 207 zum Speichern des zweiten Zustands in der Speicherzelle im Leiterbahnkomplex Alu 1 durchgeführt wird. Damit werden die zwei Speicherzustände im Verdrahtungskomplex programmiert.

Erfindungsgemäß kann jedoch der Schritt des Bereitstellens des Transistorkomplexes zunächst durchgeführt werden, um ein vorgefertigtes ROM zu erhalten, und die Schritte des Verbindens des ersten Leitungsanschlusses des Speichertransistors mit der ersten Leitung 205, des zweiten Leitungsanschlusses des Speichertransistors mit der zweiten Bitleitung 207, des Steueranschlusses des Speichertransistors mit der Wortleitung können nach dem Bereitstellen des Transistorkomplexes durchgeführt werden.

## Patentansprüche

1. ROM-Speicher mit folgenden Merkmalen:
einer ersten Speicherzelle (201) und einer der ersten Speicherzelle (201) benachbarten zweiten Speicherzelle (203), wobei die erste und die zweite Speicherzelle jeweils einen Speichertransistor mit einem ersten und einem zweiten Leitungsanschluß und einen Steueranschluß aufweisen;
einer Wortleitung (209);
einer ersten Bitleitung (205) und einer zweiten Bitleitung (207), wobei die zweite Bitleitung (207) der ersten Bitleitung (205) benachbart ist, wobei durch die erste Bitleitung (205) die erste Speicherzelle (201) auslesbar ist und wobei durch die zweite Bitleitung (207) die zweite Speicherzelle (203) auslesbar ist;
wobei die erste Bitleitung (205) mit dem ersten Leitungsanschluß (20111) des Speichertransistors (2011) der ersten Speicherzelle (201), unabhängig von einem Zustand, der in der ersten Speicherzelle (201) speicherbar ist, verbunden ist;
wobei die zweite Bitleitung (207) mit dem zweiten Leitungsanschluß (20311) des Speichertransistors (2011) der ersten Speicherzelle (201) verbunden ist;
wobei der Steueranschluß (20115) der ersten Speicherzelle (201) zum Speichern eines ersten Zustands mit der Wortleitung (209) verbunden ist oder zum Speichern eines zweiten Zustands, der sich von dem ersten Zustand unterscheidet, mit der zweiten Bitleitung (207) verbunden ist;
einer Einrichtung (213) zum Legen der zweiten Bitleitung (207) auf ein Referenzpotential, wenn die erste Bitleitung (205) auf ein Bitleitungslesepotential gelegt wird; und
einer Einrichtung (211) zum Auslesen, wobei die Einrichtung (211) zum Auslesen ausgebildet ist, um die erste Bitleitung (205) auf das Bitleitungslesepotential zu legen und die Wortleitung (209) auf ein Wortleitungslesepotential zu legen, wobei ein stabiles Potential auf der ersten Bitleitung (205) den zweiten Zustand in der ersten Speicherzelle (201) anzeigt und ein bezüglich des Bitleitungslesepotentials verändertes Potential auf der ersten Bitleitung (205) den ersten Zustand in der ersten Speicherzelle (201) anzeigt.

2. ROM-Speicher gemäß Anspruch 1 mit folgenden Merkmalen:
einer weiteren Bitleitung (401), wobei die weitere Bitleitung (401) mit dem zweiten Leitungsanschluß (20313) des Speichertransistors (2031) der zweiten Speicherzelle (203) verbunden ist;
wobei die zweite Bitleitung (207) mit dem ersten Leitungsanschluß (20315) des Speichertransistors (2031) der zweiten Speicherzelle (203), unabhängig von dem Zustand, der in der zweiten Speicherzelle (203) speicherbar ist, verbunden ist, um die zweite Speicherzelle (203) auszulesen, wobei der Steueranschluß (20315) des Speichertransistors (2031) der zweiten Speicherzelle (203) zum Speichern des ersten Zustands mit der Wortleitung (209) verbunden ist oder zum Speichern des zweiten Zustands mit der weiteren Bitleitung (401) verbunden ist;
einer weiteren Einrichtung (403) zum Legen der weiteren Bitleitung (401) auf das Referenzpotential, wenn auf die zweite Bitleitung (207) ein Bitleitungslesepotential gelegt wird;
wobei die Einrichtung (211) zum Auslesen ausgebildet ist, um die zweite Bitleitung (207) auf das Bitleitungslesepotential zu legen und die Wortleitung (209) auf das Wortleitungslesepotential zu legen.

3. ROM-Speicher gemäß Anspruch 2 mit folgenden Merkmalen:
einer dritten Speicherzelle (501) und einer vierten Speicherzelle (503), wobei die dritte Speicherzelle (501) und die vierte Speicherzelle (503) jeweils einen Speichertransistor aufweisen;
wobei ein erster Leitungsanschluß (50111) des Speichertransistors (5011) der dritten Speicherzelle (501) mit der ersten Bitleitung (205) zum Auslesen der dritten Speicherzelle (501) verbunden ist, ein zweiter Leitungsanschluß (50113 des Speichertransistors (5011) der dritten Speicherzelle (501) mit der zweiten Bitleitung (207) verbunden ist, ein erster Leitungsanschluß (50311) des Speichertransistors (5031) der vierten Speicherzelle (503) mit der zweiten Bitleitung (207) zum Auslesen der vierten Speicherzelle (503) verbunden ist, und ein zweiter Leitungsanschluß (50313) des Speichertransistors (5031) der vierten Speicherzelle (503) mit der weiteren Bitleitung (401) verbunden ist;
einer weiteren Wortleitung (505), wobei der Steueranschluß (50115) des Speichertransistors (5011) der dritten Speicherzelle (501) zum Speichern des ersten Zustands mit der weiteren Wortleitung (505) verbunden ist oder zum Speichern des zweiten Zustands mit der zweiten Bitleitung (207) verbunden ist, und wobei der Steueranschluß (50315) des Speichertransistors (5031) der vierten Speicherzelle (503) zum Speichern des ersten Zustands mit der weiteren Wortleitung (505) verbunden ist oder zum Speichern des zweiten Zustands mit der weiteren Bitleitung (401) verbunden ist;
wobei die Einrichtung (211) zum Auslesen ausgebildet ist, um wahlweise die erste Wortleitung (209) auf das Wortleitungsaktivierungspotential zu legen und die weitere Wortleitung (505) nicht auf das Wortleitungslesepotential zu legen, so daß der Zustand der ersten oder der zweiten Speicherzelle auslesbar ist.

4. ROM-Speicher gemäß Anspruch 2 oder 3, wobei die Einrichtung (211) zum Auslesen ausgebildet ist, um zum Auslesen der zweiten Speicherzelle (203) die erste Bitleitung (205) von dem Referenzpotential und dem Bitleitungslesepotential abzutrennen.

5. ROM-Speicher gemäß einem der Ansprüche 2 bis 4, wobei zum Auslesen der ersten Speicherzelle (201) die weitere Einrichtung (403) zum Legen der weiteren Bitleitung (401) auf das Referenzpotential deaktiviert ist.

6. ROM-Speicher gemäß einem der Ansprüche 4 bis 5, bei dem die Einrichtung (211) zum Auslesen folgende Merkmale aufweist:
einen ersten Schalter (2111), der zwischen das Bitleitungslesepotential und die erste Bitleitung (205) gekoppelt ist und der durch ein Ansteuersignal zum Auslesen der ersten Bitleitung (205) steuerbar ist;
einen zweiten Schalter (2131), der zwischen die erste Bitleitung (205) und einen Sensorverstärker gekoppelt ist und der durch das Ansteuersignal steuerbar ist;
wobei das Ansteuersignal den ersten und den zweiten Schalter steuert, um auf die erste Bitleitung (205) das Bitleitungslesepotential zu legen und um die erste Bitleitung (205) mit dem Sensorverstärker zu verbinden.

7. ROM-Speicher gemäß Anspruch 6, bei dem die Einrichtung (213) zum Legen der zweiten Bitleitung (207) auf das Referenzpotential einen dritten Schalter (2131) aufweist, der zwischen die zweite Bitleitung (207) und Referenzpotential gekoppelt ist und durch das Ansteuersignal steuerbar ist;
wobei das Ansteuersignal den ersten, zweiten und den dritten Schalter steuert, um auf die zweite Bitleitung (207) das Referenzpotential zu legen, wenn die erste Bitleitung (205) ausgelesen wird.

8. ROM-Speicher gemäß Anspruch 6 bis 7, bei dem die Einrichtung (211) zum Auslesen ferner einen vierten Schalter aufweist, der zwischen die erste Bitleitung (205) und das Bitleitungslesepotential gekoppelt ist und der durch ein Ladesignal steuerbar ist, um die erste Bitleitung (205) auf das Bitleitungslesepotential zwischen einem ersten und einem zweiten Lesezugriff auf die erste Bitleitung (205) zu legen.

9. ROM-Speicher gemäß einem der Ansprüche 6 bis 8, bei dem die Schalter p-Kanal-Feldeffekttransistoren sind und die Speichertransistoren n-Kanal-Feldeffekttransistoren sind.

10. ROM-Speicher gemäß einem der Ansprüche 6 bis 9, bei dem die Einrichtung (211) zum Auslesen einen steuerbaren Bitleitungsadreßdecoder (603) aufweist, der ausgebildet ist, um das Ansteuersignal zum Auslesen der ersten Bitleitung (205) zu liefern, wenn die erste Bitleitung (205) ausgelesen wird.

11. ROM-Speicher gemäß einem der Ansprüche 6 bis 10, bei dem die Einrichtung (211) zum Auslesen einen steuerbaren Wortleitungsadreßdecoder (601) aufweist, der ausgebildet ist, um die Wortleitung (209) auf das Wortleitungsaktivierungspotential zu legen, um entweder den ersten oder den zweiten Zustand in der ersten Speicherzelle (201) auszulesen.

12. ROM-Speicher gemäß einem der Ansprüche 6 bis 11, bei dem der Sensorverstärker ausgebildet ist, um auf der Basis eines Vergleichs zwischen einem Vergleichspotential und dem Potential auf der ersten Bitleitung (205) ein Detektionssignal zu liefern, das den ersten oder den zweiten Zustand in der ersten Speicherzelle (201) anzeigt.

13. ROM-Speicher gemäß Anspruch 12, bei dem der Sensorverstärker folgende Merkmale aufweist:
einen Vergleicher mit einem ersten Eingang, an den das Vergleichspotential anlegbar ist, einem zweiten Eingang, der mit dem zweiten Schalter (2131) der Einrichtung (211) zum Auslesen gekoppelt ist, um das Potential auf der ersten Bitleitung (205) zu detektieren, und einem Ausgang, an den das Detektionssignal lieferbar ist;
einen Schalter zum Legen des Bitleitungslesepotentials an den zweiten Eingang zwischen einem ersten und einem zweiten Lesezugriff, um eine Verbindungsstrecke zum zweiten Schalter (2131) aufzuladen.

14. ROM-Speicher gemäß einem der Ansprüche 12 bis 13, bei dem der Sensorverstärker ein Speicherelement aufweist, um das Detektionssignal bis zu einem nächsten Detektionsvorgang zu speichern.

15. ROM-Speicher gemäß einem der Ansprüche 1 bis 14, bei dem das Referenzpotential nahe dem Massepotential ist.

16. Verfahren zum Auslesen eines ROM-Speichers mit:
einer ersten Speicherzelle (201), die einen ersten Speichertransistor (2011) mit einem ersten Leitungsanschluß (20111), einem zweiten Leitungsanschluß (20113) und einem Steueranschluß (20115) aufweist;
einer der ersten Speicherzelle (201) benachbarten zweiten Speicherzelle (203), die einen zweiten Speichertransistor (2031) mit einem ersten Leitungsanschluß (20311), einem zweiten Leitungsanschluß (20313) und einem Steueranschluß (20315) aufweist;
einer ersten Bitleitung (205) zum Auslesen der ersten Speicherzelle (201), die mit dem ersten Leitungsanschluß (20111) des ersten Transistors (2011) verbunden ist;
einer zweiten Bitleitung (207), die mit dem zweiten Leitungsanschluß (20113) des ersten Speichertransistors (2011) verbunden ist;
wobei der Steueranschluß (20115) des ersten Speichertransistors (2011) zum Speichern eines ersten Zustands mit der Wortleitung (209) verbunden ist oder zum Speichern eines zweiten Zustands, der sich von dem ersten Zustand unterscheidet, mit der zweiten Bitleitung verbunden ist, mit folgenden Schritten:
Legen der ersten Bitleitung (205) auf ein Bitleitungslesepotential zum Auslesen der ersten Speicherzelle (201);
Legen der zweiten Bitleitung (207) auf ein Referenzpotential, das sich von dem Bitleitungslesepotential unterscheidet, während die erste Speicherzelle (201) ausgelesen wird;
Legen der Wortleitung (209) auf ein Wortleitungslesepotential zum Auslesen der ersten Speicherzelle (201);
Auslesen eines Potentials auf der ersten Bitleitung (205), wobei ein stabiles Potential auf der ersten Bitleitung (205) den zweiten Zustand in der ersten Speicherzelle (201) anzeigt und ein bezüglich des Bitleitungslesepotentials verändertes Potential den ersten Zustand in der ersten Speicherzelle (201) anzeigt.

17. Verfahren gemäß Anspruch 16, bei dem der ROM-Speicher eine weitere Bitleitung (401) aufweist, die mit dem zweiten Leitungsanschluß (20313) des zweiten Speichertransistors (2031) der zweiten Speicherzelle (203) verbunden ist, wobei der Steueranschluß (20315) des zweiten Speichertransistors (2031) zum Speichern des ersten Zustands mit der Wortleitung (209) verbunden ist, oder zum Speichern des zweiten Zustands mit der weiteren Bitleitung (401) verbunden ist, das nach einem Auslesen der ersten Speicherzelle (201) folgende Schritte aufweist:
Trennen der zweiten Bitleitung (207) von dem Referenzpotential;
Legen des Bitleitungslesepotentials auf die zweite Bitleitung (207) zum Auslesen der zweiten Speicherzelle (203);
Legen des Referenzpotentials auf die weitere Bitleitung (401), während die zweite Speicherzelle (203) ausgelesen wird;
Auslesen der zweiten Speicherzelle (203).

18. Verfahren zum Herstellen eines ROM-Speichers mit folgenden Schritten:
Bereitstellen eines Substrats, wobei das Substrat eine Speicherzelle, einen Speichertransistor mit einem ersten Leitungsanschluß, einem zweiten Leitungsanschluß und einem Steueranschluß aufweist;
Bereitstellen einer ersten Bitleitung (205);
Bereitstellen einer zweiten Bitleitung (207); und
Bereitstellen einer Wortleitung (209);
Verbinden des ersten Leitungsanschlusses des Speichertransistors mit der ersten Bitleitung (205);
Verbinden des zweiten Leitungsanschlusses des Speichertransistors mit der zweiten Bitleitung;
Verbinden des Steueranschlusses des Speichertransistors mit der Wortleitung (209) zum Speichern eines ersten Zustands in der Speicherzelle oder Verbinden des Steueranschlusses des Speichertransistors mit der zweiten Bitleitung zum Speichern eines zweiten Zustands in der Speicherzelle.

19. Verfahren gemäß Anspruch 18, wobei zum Bereitstellen der jeweiligen Bitleitung und der Wortleitung sowie zum Verbinden der jeweiligen Anschlüsse des Speichertransistors eine Maske verwendet wird.

20. Verfahren zum Herstellen des Transistorkomplexes gemäß Anspruch 18, mit einem Schritt des Bereitstellens von Speichertransistoren zum Speichern des ersten Zustands in der Speicherzelle;
wobei die Speichertransistoren zum Speichern des zweiten Zustands nicht bereitgestellt werden.

21. Verfahren gemäß Anspruch 18,
bei dem der Schritt des Verbindens der Wortleitung mit dem Steueranschluß des Speichertransistors zum Speichern des ersten Zustands in der Speicherzel in einem Kontaktfensterkomplex Alu 1 zu Alu 2 durchgeführt wird; und
bei dem der Schritt des Bereitstellens der zweiten Bitleitung (207) und des Verbindens des Steueranschlusses des Speichertransistors mit der zweiten Bitleitung (207) zum Speichern des zweiten Zustands in der Speicherzelle in einem Verdrahtungskomplex durchgeführt wird.

22. Verfahren gemäß Anspruch 18,
bei dem der Schritt des Bereitstellens des Transistorkomplexes zunächst durchgeführt wird, um ein vorgefertigtes ROM zu erhalten, und
bei dem die Schritte des Verbindens des ersten Leitungsanschlusses des Speichertransistors mit der ersten Leitung (205), des zweiten Leitungsanschlusses des Speichertransistors mit der zweiten Bitleitung (207), des Steueranschlusses des Speichertransistors mit der Wortleitung nach dem Bereitstellen des Transistorkomplexes durchgeführt werden.
